**Europäisches Patentamt**

**European Patent Office**

**Office européen des brevets**

(11) Publication number : **0 329 793 B1**

# EUROPEAN PATENT SPECIFICATION

(45) Date of publication of patent specification :
25.10.95 Bulletin 95/43

(51) Int. Cl.⁶ : **H03K 19/0175**, H03K 5/15,
H03F 1/22, H03F 3/45

(21) Application number : **88906881.3**

(22) Date of filing : **28.07.88**

(86) International application number :
PCT/JP88/00758

(87) International publication number :
WO 89/01262 09.02.89 Gazette 89/04

(54) HIGH-SPEED ELECTRONIC CIRCUIT HAVING A CASCODE CONFIGURATION.

(30) Priority : 29.07.87 JP 189848/87
29.07.87 JP 189849/87
29.07.87 JP 189850/87
29.07.87 JP 189851/87
30.07.87 JP 191040/87
16.09.87 JP 231818/87

(43) Date of publication of application :
30.08.89 Bulletin 89/35

(45) Publication of the grant of the patent :
25.10.95 Bulletin 95/43

(84) Designated Contracting States :
DE FR GB

(56) References cited :
EP-A- 0 031 226
EP-A- 0 093 996
EP-A- 0 121 027
EP-A- 0 144 647
EP-A- 0 148 395
EP-A- 0 230 693
FR-A- 2 438 938
GB-A- 909 776
GB-A- 2 057 800
US-A- 3 200 343
US-A- 3 283 170
US-A- 3 496 385
US-A- 3 516 003
US-A- 4 121 169
Patent Abstracts of Japan, volume 12, no. 200
(E-619)(3047), 9 June 1988; & JP-A-631211 (FU-
JITSU LTD) 6 January 1988
Electronique Applications, no. 44,
October/November 1985, (Paris, FR)
H.Schreiber: "Le montage 'cascode désadap-
té'", pages 49-51

(73) Proprietor : **FUJITSU LIMITED**
1015, Kamikodanaka,
Nakahara-ku
Kawasaki-shi, Kanagawa 211 (JP)

(72) Inventor : **HAMANO, Hiroshi** Miyoshi-so, 864
Shimonoge
Takatsu-ku Kawasaki-shi Kanagawa 213 (JP)
Inventor : **AMEMIYA, Izumi** Bamuhaitsu
Kikuna 3-306
1-30, Uenomiya
Tsurumi-ku, Yokohama-shi Kanagawa 230 (JP)
Inventor : **YAMAMOTO, Takuji** 6-22-24,
Masugata
Tama-ku
Kawasaki-shi Kanagawa 214 (JP)
Inventor : **KITASAGAMI, Hiroo** Shintamagawa
Haimu 2-208
1048-1, Nakanoshima
Tama-ku, Kawasaki-shi Kanagawa 214 (JP)
Inventor : **IHARA, Takeshi** Sanraizu Shinjo 204
1-17-14, Shinjo
Nakahara-ku, Kawasaki-shi Kanagawa 211
(JP)

(74) Representative : **Ritter und Edler von Fischern,
Bernhard,Dipl.-Ing. et al**
Hoffmann, Eitle & Partner,
Patentanwälte,
Postfach 81 04 20
D-81904 München (DE)

(56) References cited :

IBM Technical Dislosure Bulletin, volume 23, no. 1, June 1980, (New York, US),V.S. Moore et al.: "Differential amplifier gain-bandwidth circuit with adifferentially driven load", pages 48,49

Patent Abstracts of Japan, volume 9, no. 193 (E-334)(1916), 9 August 1985; & JP-A-6059813 (SONY K.K.) 6 April 1985

Patent Abstracts of Japan, volume 9, no. 102 (E-312)(1825), 4 May 1985; & JP-A-59228430 (HITACHI SEISAKUSHO K.K.) 21 December 1984

Patent Abstracts of Japan, volume 5, no. 34 (E-48)(706), 4 March 1981; & JP-A-55161421 (MATSUSHITA DENKI SANGYO K.K.) 16 December 1980

IBM Technical Disclosure Bulletin, volume 20, no. 7, December 1977, (New York,US), L.W. Brown et al.: "Interconnection of logic circuits", pages 2537-2540

The General Radio Experimenter, volume 42, no. 10, October 1968, (Concord, US), "How it works", page 13

IEEE Journal on Solid-State Circuits, volume SC-21, no. 1, February 1986, IEEE,(New York, US), Chii-Fa Chiou et al.: "Design and performance of a fullyintegrated bipolar 10.7-MHZ analog bandpass filter", pages 6-14

IEEE Journal of Solid-State Circuits, volume SC-21, no. 4, August 1986, IEEE,(New York, US), F. Hérbert et al.: "Compensation of bipolar monolithic circuitsusing the parasitic capacitance of diffused resistors", pages 568-574

EDN Electrical Design News, volume 31, no. 4, 20 February 1986, (Boston,Massachusetts, US), F. Boes: "Wien-bridge filters en-hance tone control", page241

Patent Abstracts of Japan, (7700)(E77); & JP-A- 5289043 (MATSUSHITA DENKISANGYO K.K.) 26 July 1977

Instruments and Experimental Techniques, volume 16, no. 4, July/August 1973,Consultants Bureau, a division of Plenum Publishing Corp., (New York, US), A.A.Lysenko et al.: "A broadband oscillascopic amplifier for the nanosecond range", pages 1173-1175

# Description

High-speed Electronic Circuit Having a Cascode Configuration

## Technical Field

The present invention relates to an electronic circuit having a cascode configuration. More particularly, it relates to an electronic circuit able to operate at a high speed and/or having a wide frequency band.

## Background Art

Recent technology advances in data processing systems, such as high speed data communication systems, require improved electronic circuits able to process data at a high speed and/or at a wide frequency band. In particular, for example, in an optical-fiber data communication system, a very high speed data transmission of more than 1.6 giba-bits per second (Gbs) has been attempted, to increase a transmission rate to a propagation speed limit of an optical fiber cable which has a very wide frequency range.

To achieve a high speed operation, a wide frequency margin, and a high stability, a variety of consideration, such as a careful selection of circuit elements applied to such electronic circuits, a design of a best circuit arrangement, a rejection of adverse affects by, for example, a stray capacitance and a stray inductance, must be taken into account. Various types of electronic circuits have been applied to such high speed data transmission systems, as an interface circuit, a level shift circuit, a discrimination circuit, etc. However, these prior art electronic circuits still do not provide a satisfactory performance. The prior art electronic circuits will be described with reference to specific examples.

JP-A-6059813 describes a latched comparator including a voltage comparator having two input transistors whose emitters are commonly connected and operatively grounded. The collectors of the transistors are connected to load resistors respectively via switching transistors. The emitters of switching transistors are connected to the collectors of the input transistors and the collectors of the switching transistors are connected to the load transistors.

## DISCLOSURE OF THE INVENTION

An object of the present invention is to provide an improved electronic circuit having a high speed operation time, a wide frequency range and/or a great stability.

Another object of the present invention is to provide an improved level shift circuit able to operate at a high speed.

Still another object of the present invention is to provide an improved level shift circuit having a great stability at a high frequency range.

Yet another object of the present invention is to provide an improved discrimination circuit able to discriminate a signal level with a high accuracy.

Another object of the present invention is to provide an improved signal synthesization circuit having many fan-ins.

The objects of the invention are solved by a level shift circuit comprising: a current drive circuit including at least one input transistor, the emitter thereof being operatively grounded and a base thereof receiving a respective input signal; a load transistor circuit including at least one load transistor, the base of each load transistor being operatively grounded, the emitter of each load transistor being connected to the collector of a respective input transistor; a bias current source connected between said emitter of said load transistor and ground, a respective current generated by said bias current source being supplied to each load transistor to maintain a forward base emitter voltage of each load transistor; and a load resistor circuit including at least one load resistor connected between the collector of a respective load transistor in said load transistor circuit and a power supply voltage, an output signal being provided at the collector of each load transistor; characterized in that said bias current source comprises a current mirror circuit for each current to be provided, at least one of said current mirror circuits being connected to a control voltage source to shift the level of said output signal by a value defined by the control voltage source.

In a preferred embodiment of the invention said current drive circuit includes first and second input transistors connected in parallel to differentially operate in response to two input signals connected to bases thereof and a current source connected between emitters of said first and second input transistors and ground, said load transistor circuit includes first and second load transistors, the emitter of said first load transistor being connected to the collector of said first input transistor, the emitter of said second load transistor being connected to the collector of said second input transistor and bases of said first and second load transistors being commonly connected and operatively grounded, said load resistor circuit includes two load resistors connected to collectors of said first and second load transistors, respectively, to output two output signals from points at which said collectors and said load resistors are commonly connected, and said current-mirror circuit includes first to third current source transistors connected in parallel, collectors of said first and second current source transistors being respectively connected to said emitters of said first and second load transistors, the control voltage source being connected to a collector of said third current source transistor, the collector of said third current source transistor being connected to a base thereof which is commonly connected to the base of said second current source transistor and second to fourth current source resistors respectively connected between emitters of said first to third current source transistors and ground.

In a modification to the preferred embodiment a latch circuit (FF) is connected to said load resistor circuit. Such a circuit can operate as a signal discrimination circuit.

In a further preferred embodiment said current drive circuit includes first and second input transistors connected in parallel to differentially operate in response to two input signals connected to bases thereof and a current source connected between emitters of said first and second input transistors and ground, said load transistor circuit includes first and second load transistors, the emitter of said first load transistor being connected to the collector of said first input transistor, the emitter of said second load transistor being connected to the collector of said second input transistor and bases of said first and second load transistors being commonly connected and operatively grounded, said load resistor circuit includes two load resistors connected to collectors of said first and second load transistors, respectively, to output two output signals from points at which said collectors and said load resistors are commonly connected, and said bias current source includes the first and a second current mirror circuit connected to said first and second load transistors, respectively.

In still a further embodiment a plurality of said current drive circuits are connected in parallel, each current drive circuit receiving a said input signal to be synthesized, said bias current source and said emitter of said at least one load transistor in said load transistor circuit are connected to the commonly connected collectors of said parallel current drive circuits. Such a circuit can be used as a signal synthesizing circuit.

Brief Description of Drawings

Figures 1a to 1d are circuit diagrams of prior art interface circuits;
Figs. 2a and 2b are graphs representing frequency characteristics of the interface circuits shown in Figs. 1a to 1d;
Fig. 3 is a principle circuit diagram of an interface circuit;
Fig. 4 is a graph representing a frequency characteristic of the interface circuit shown in Fig. 3;
Figs. 5a and 5b are specific circuit diagram of the interface circuit shown in Fig. 3;
Figs. 6a and 6b are graphs representing rising and trailing wave forms of an output signal in Fig. 3;
Figs. 7a and 7b are circuit diagrams explaining the rising and trailing operation of the interface circuit shown in Fig. 3;
Figs. 8a and 8b are circuit diagrams showing the principle of an interface circuit;
Figs. 9a and 9b are graphs representing rising and trailing wave forms of an output signal in Figs. 8a and 8b;
Figs. 10a to 10d are circuit diagrams of interface circuits;
Figs. 11 and 12 are circuit diagrams of prior art level shift circuits;
Fig. 13 is a graph representing the frequency characteristic of the level shift circuit shown in Fig. 11;
Fig. 14 is a circuit diagram showing the principle of a level shift circuit;
Figs. 15 and 18 are circuit diagrams of conventional level shift circuits;
Figs.16 and 17 are circuit diagrams of embodiments of a level shift circuit in accordance with the present invention;
Figs.19 to 23a and 23b are views representing a signal discrimination circuit;
Fig. 24 is a circuit diagram showing the principle of a signal discrimination circuit;
Figs. 25 to 27 are circuit diagrams of embodiments of the signal discrimination circuit in accordance with the present invention;
Figs. 28 and 29 are circuit diagrams of prior art signal distribution circuits;
Figs. 30 and 31 are circuit diagrams showing the principle of signal distribution circuits;
Figs. 32 to 37 are circuit diagrams of signal distribution circuits;
Figs. 38 and 39 are circuit diagrams of prior art signal synthesization circuits;
Figs. 40 to 42 are circuit diagrams showing the principle of signal synthesization circuits;
Fig. 43 is a circuit diagram of an embodiment of a signal synthesization circuit in accordance with the present invention.

Best Mode for Carrying Out the Invention

First, an interface circuit, will be described.
Prior art interface circuits will be described with reference to the drawings.

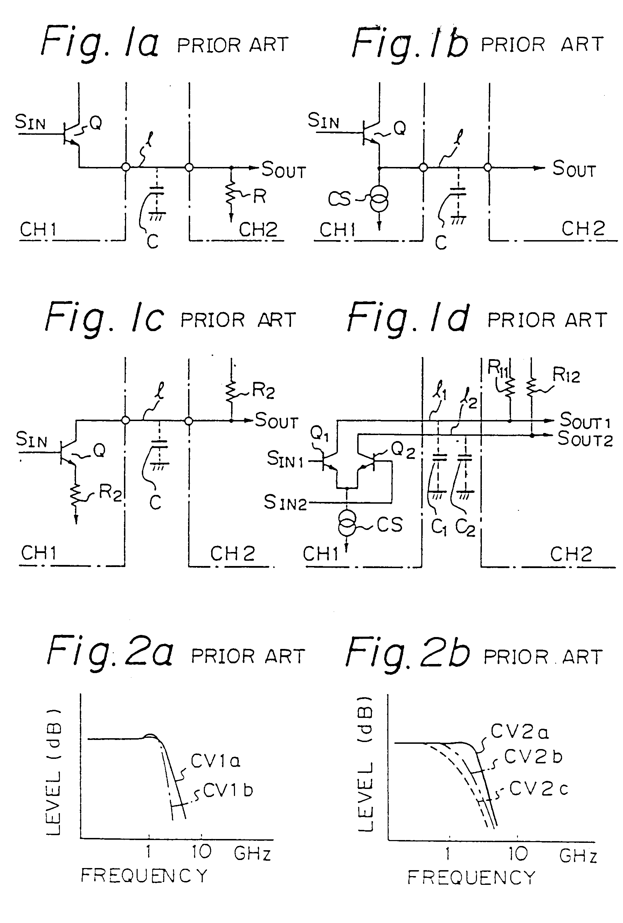

Figures 1a to 1d show prior art interface circuits. Figure 1a shows an open-emitter type interface circuit, Fig. 1b shows an emitter-follower type interface circuit, Fig. 1c shows an open-collector type interface circuit, and Fig. 1d shows a differential-operation and open-collector type interface circuit. In the drawings, reference CH1 denotes a transmission side integrated circuit (IC) chip, CH2 denotes a reception side IC chip, Q, $Q_1$ and $Q_2$ denote npn-type transistors, R, $R_{11}$ and $R_{12}$ denote resistors, CS denotes a constant current source, $\ell$, $\ell_1$ and $\ell_2$ denote data transmission lines, and C, $C_1$ and $C_2$ denote stray capacitors. The IC chip CH1 is provided at a data transmission side, the IC chip CH2 is provided at a data reception side, and the data transmission line(s) $\ell$ or $\ell_1$ and $\ell_2$ is (are) provided therebetween. The stray capacitor(s) C or $C_1$ and $C_2$ may be connected to the data transmission line(s) $\ell$ or $\ell_1$ and $\ell_2$.

The open-emitter type interface circuit shown in Fig. 1a is a voltage signal propagation type interface circuit. An input impedance of the transmission side IC chip CH1 is low, and an input impedance of the reception side IC chip IC2 is high. A frequency band $f_{-3dB}$ at which a gain is lowered by 3 dB is expressed by the following formula:

$$f_{-3dB} = \frac{1}{2\,C_S \cdot r_E} \quad (1)$$

where,

$C_S$ represents a capacitance of the stray capacitor(s) C or $C_1$ and $C_2$ , and

$r_e$ represents an emitter resistance of the transistor(s) Q or $Q_1$ and $Q_2$.

Figure 2a shows a frequency characteristic of the open-type interface circuit shown in Fig. 1a. In the drawing, curve $CV1_a$ shows a frequency characteristic when the stray capacitance $C_S$ is 0.5 pF, and curve $CV1_b$ shows a frequency characteristic when the stray capacitance $C_S$ is 5 pF. Since the emitter resistance $r_E$ is small, an affect due to the stray capacitor is reduced and a frequency band where a gain is lowered by 3 dB is broad, but a distortion, such as peaking occurs.

The emitter-follower type interface circuit shown in Fig. 1b also suffers from the above defect.

In Figs. 1c and 1d, since the load resistor(s) $R_1$ or $R_{11}$ and $R_{12}$ is (are) connected to the stray capacitor(s) in parallel, the frequency $f_{-3dB}$ is expressed as follows:

$$f_{-3dB} = \frac{1}{2\,R_L \cdot C_S} \quad (2)$$

where, $R_L$ represents a resistance of the load resistor(s) $R_1$ or $R_{11}$ and $R_{12}$.

Figure 2b shows a frequency characteristic of the interface circuits shown in Figs. 1c and 1d. In Figs. 2b, curves $CV2_a$ , $CV2_b$ , and $CV2_c$ show frequency characteristics where the stray capacitance $C_S$ are 0.1 pF, 0.5 pF and 1.0 pF, respectively. The resistance $R_L$ of the load resistor(s) $R_1$ or $R_{11}$ and $R_{12}$ can not be made too small because an output signal(s) $S_{OUT}$ or $S_{OUT1}$ and $S_{OUT2}$ having a predetermined amplitude must be provided, an affect due to the stray capacitance $C_S$ can not be eliminated, as shown in Fig. 2b.

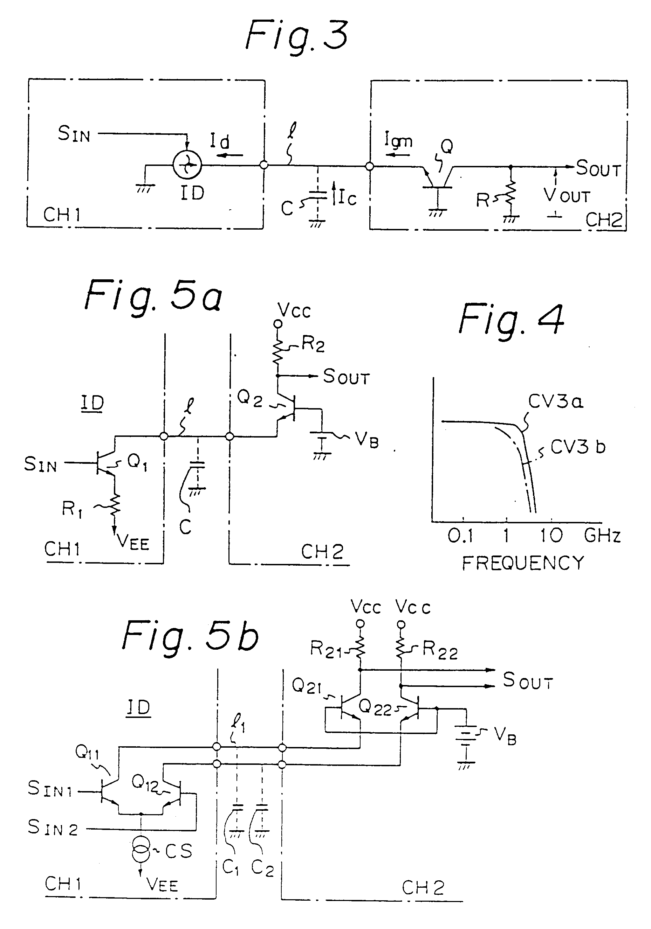

The inventors of the present application devised a novel interface circuit which definitely eliminates the above adverse affect due to the stray capacitance ("Interface circuit", filed on June 20, 1986 at Japan P.O. and published on January 6, 1988, as JPA 63-1211). Figure 3 shows a principle interface circuit, which comprises a current drive source ID in a transmission side IC chip CH1, and, an npn-type transistor Q in which a base is grounded and an emitter is connected to the current drive source ID through a transfer line $\ell$, and a load resistor R in a reception side IC chip CH2. A stray capacitor C may be connected to the transfer line $\ell$. A current $I_d$ which is extracted from the current drive source ID is defined by the following formula:

$$I_d = I_c + I_{gm} \quad (3)$$

where,

$I_c$ is a current supplied by the stray capacitor C, and

$I_{gm}$ is a current supplied by the transistor Q.

An output voltage $V_{OUT}$ of an output signal $S_{OUT}$ is expressed as follows:

$$V_{OUT} = R_L \cdot I_{gm} \quad (4)$$

where, $R_L$ is a resistance of the load resistor R.

A voltage $V_C$ generated at the stray capacitor C is expressed by

$$V_C = \frac{I_c}{jwC_S} = \frac{I_{gm}}{g_m} \quad (5)$$

where,

$C_S$ is a capacitance of the stray capacitor C, and

$g_m$ is a mutual conductance of the transistor Q.

Accordingly, from the above formulas (3) to (5), the output voltage $V_{OUT}$ of the output signal $S_{OUT}$ is expressed by the following formula:

$$V_{OUT} = R_L \cdot \frac{1}{1 + \dfrac{jwC_S}{g_m}} I_d \quad (6)$$

As a result, a frequency $f_{-3dB}$, a gain which is lowered by 3 dB, is expressed by the following formula:

$$f_{-3dB} = \frac{g_m}{2\pi C_S} \quad (7)$$

Figure 4 shows a graph of a frequency characteristic of the interface circuit shown in Fig 3. In the drawing, curves $CV3_a$ and $CV3_b$ show the frequency characteristics when the stray capacitances $C_S$ are 1 pF and 5 pF, respectively. More concretely, when a DC current component of the current drive source ID is 2 mA, a resistance: $1/g_m$ is 13 $\Omega$ and, when the stray capacitance $C_S$ is 1 pF, the frequency $f_{-3dB}$ is 12 Giga-Hertz (GHz). Apparently, this interface circuit shown in Fig. 3 is not substantially affected by the stray capacitance $C_S$ of approximately 1 pF on s signal transfer at approximately 10 GHz.

Figures 5a and 5b show specific circuits of the interface circuit of shown in Fig. 3. The circuit shown in Fig. 5a comprises the current drive source ID consisting of an npn-type transistor $Q_1$ and an emitter resistor $R_1$ having a terminal connected to an emitter of the transistor $Q_1$ and another terminal connected to a low voltage supply $V_{EE}$ which may be ground. The circuit also comprises an npn-type transistor $Q_2$ having an emitter connected to a collector of the transistor $Q_1$ through the transfer line $\ell$ and a base supplied with a bias voltage supply $V_B$ , and a load resistor $R_2$ connected between a high voltage supply $V_{CC}$ and a collector of the transistor $Q_2$. At the IC chip CH1, an input signal $S_{IN}$ is supplied to a base of the transistor $Q_1$ , and at the IC chip CH2, an output signal $S_{OUT}$ is output from a point at which the load resistor $R_2$ and the collector of the transistor $Q_2$ are commonly connected. The stray capacitor C is connected to the transfer line $\ell$.

Note that the interface circuit shown in Fig. 5a is formed by a "cascode configuration", since the emitter of the transistor $Q_1$ is grounded through the resistor $R_1$ , the collector of the transistor $Q_1$ and the emitter of the transistor $Q_2$ are connected, and the base of the transistor $Q_2$ is grounded through the bias voltage supply $V_B$. In general, a cascode amplifier having the above configuration is used for a high frequency amplification, because an input signal side and a load side are separated and an internal feedback is small, and thus a high speed operation can be established. A total gain of the cascode amplifier is equal to a gain of a load transistor, because a load at a first step is a resistor of an input transistor in the second step, i.e., an emitter resistance $r_E$ of the input transistor which is very small. In JPA 63-1211, the above high speed operation feature of the cascode configuration, and the elimination of the affection due to the stray capacitor by a Miller effect, obtained by grounding the base of the load transistor are used for an interface are used for an interface circuit operable at a high frequency.

In Fig. 5b, the current drive source ID is constructed by differential operation transistor pair $Q_{11}$ and $Q_{12}$ and a constant current source CS. The load (output) circuit also includes a pair of transistors $Q_{21}$ and $Q_{22}$ , a pair of load resistors $R_{21}$ and $R_{22}$ , and the bias voltage supply $V_B$. Emitters of the transistors $Q_{11}$ and $Q_{12}$ are grounded through the constant current source CS, and bases of the transistors $Q_{21}$ and $Q_{22}$ are grounded through the bias voltage supply $V_B$. Accordingly, this interface circuit shown in Fig. 5b has a cascode configuration.

Nevertheless, the interface circuit described in JPA 63-1211 still suffers from the affect of a large stray capacitance at a high frequency when the input signal $S_{IN}$ has a large amplitude, for example, 800 mV or more.

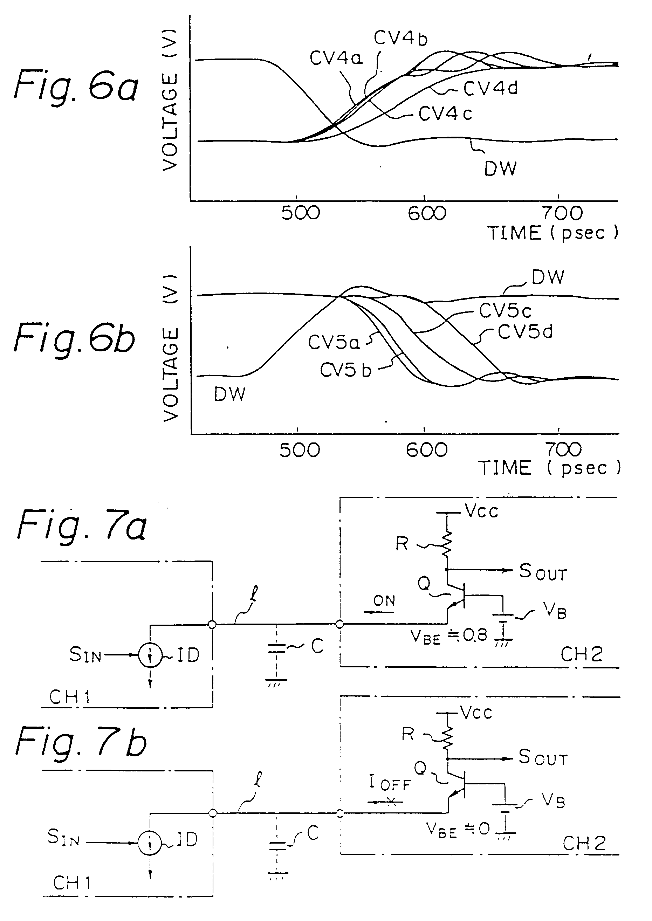

Figures 6a and 6b show graphs of response characteristics of the interface circuit shown in Fig 3, obtained by simulation. Figure 6a shows rising wave forms of the output signal $S_{OUT}$ to a drive signal, i.e., the input signal $S_{IN}$ , represented by curve DW, and Fig. 6b shows trailing (falling) wave forms to the drive signal. In Fig. 6a, curves $CV4_a$ to $CV4_d$ show rising wave forms of the output signal $S_{OUT}$ when the stray capacitances are 0.1 pF, 0.5 pF, 1.0 pF and 5.0 pF, respectively. The variation of rising times is small, but a large ringing appears due to the stray capacitance.

In Fig. 6b, curves $CV5_a$ to $CV5_d$ show trailing wave forms of the output signal $S_{OUT}$ when the stray capacitance are 0.0 pF, 0.1 pF, 0.5 pF and 1.0 pF, respectively. The start points of the trailing are greatly varied due to the stray capacitance, and the ringing is also large.

The above defects will be discussed with reference to the circuits shown in Figs. 7a and 7b, corresponding to the interface circuit shown in Fig. 3. First, an operation when the input signal $S_{IN}$ having a large amplitude and changed from low level to high level is supplied to the current drive source ID will be described with reference to Fig. 7a. Upon receipt of the high level input signal $S_{IN}$ , the current drive source ID, more specifically the transistor in the current drive source, is turned ON. As a result, the load transistor Q is also turned ON, and supplies an on current $I_{ON}$ to the current drive source ID. A voltage $V_{BE}$ between the base and the emitter of the transistor Q is varied in response to a current flowing through the base and the emitter, i.e., the on current $I_{ON}$. When the current is equal to or higher than 0.1 mA, the base-emitter voltage $V_{BE}$ of the load transistor Q is approximately 0.8 V. A voltage $V_\ell$ between the transfer line $\ell$ and ground is $V_\ell = V_B - V_{BE}$ , where $V_B$ denotes a base voltage of the transistor Q. When the flow of the on-current $I_{ON}$ occurs, the stray capacitor C is discharged until the voltage $V_\ell$ becomes $V_B - V_{BE}$ , and this distorts the rising wave form as shown in Fig. 6a. Second, an operation when the input signal $S_{IN}$ is changed from high level to low level will be described with reference to Fig. 7b. The input transistor in the current drive source ID is turned OFF, and the load transistor Q is turned OFF. As a result, an off current $I_{OFF}$ supplied from the load transistor Q to the current drive source ID becomes approximately 0 mA, and the voltage $V_{BE}$ becomes 0 V. Consequently, the voltage $V_\ell$ on the transfer line $\ell$ becomes $V_B$. The stray capacitor C is charged until the voltage $(V_B - V_{BE})$ becomes $V_B$. This distorts the trailing wave form as shown in Fig. 6b. Namely, the voltage $V_\ell$ on the transfer line $\ell$ is varied by the voltage $V_{BE} \fallingdotseq 0.8$ V, and the stray capacitor C is discharged or charged in response to the change of the transfer line voltage $V_\ell$. A delay time $t_d$ of the trailing edge and the rising edge can be expressed by the following formula:

$$t_d = \frac{C_S V_{BE}}{I_d} \quad (8)$$

where,

$I_d$ represents a current passing through the current drive source ID.

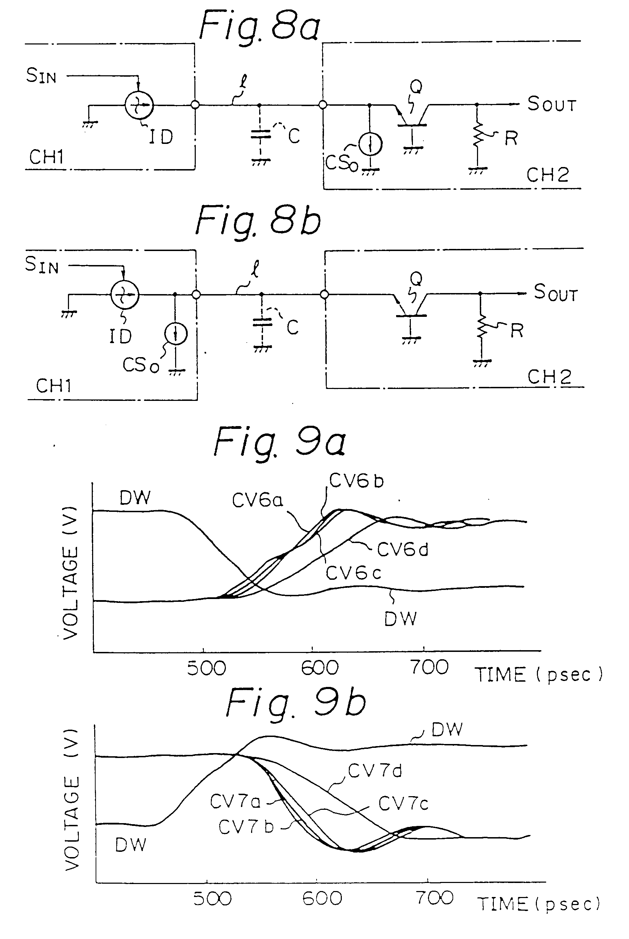

Now, a principle of an interface circuit will be described with reference to Figs. 8a and 8b. The interface circuits shown in Figs. 8a and 8b eliminate the change of the transfer line voltage $V_\ell$ , and thus eliminate the charging and discharging of the stray capacitor C, to shorten the rising time and the trailing time.

In Fig. 8a, the interface circuit includes a current drive source ID in a transmission side IC chip CH1. The interface circuit also includes, at a reception side IC chip CH2, a load (output) transistor Q and a load resistor R. Between the chips CH1 and CH2, a transfer line $\ell$ is provided, and a stray capacitor C can be connected to the transfer line $\ell$. The current drive circuit ID includes an input transistor (not shown), an emitter thereof being grounded. A base of the load transistor Q is connected to a collector of the input transistor, and a base thereof is grounded. The above circuit construction is substantially the same as that of the interface circuit shown in Fig. 3, and thus the interface circuit shown in Fig. 8a has a cascode configuration. In addition to the above circuit configuration, the interface circuit shown in Fig. 8a includes a bias current source $CS_0$ connected between the emitter and the base of the load transistor Q in the reception side IC chip CH2. The bias current source $CS_0$ provides a constant current $I_{CS}$ corresponding to a current $I_{BE}$ flowing through the base and the emitter of the load transistor, i.e., the above on-current $I_{ON}$, Q when the transistor Q is turned ON, for cancelling the current $I_{BE}$. Namely, the constant current $I_{CS}$ has an amplitude sufficient to prevent the change of the voltage $V_\ell$ on the transfer line $\ell$, i.e., to prevent the change of the base-emitter voltage $V_{BE}$ of the load transistor and has a polarity which is the reserve of a polarity of the on current $I_{ON}$. In other words, the constant current $I_{CS}$ generates a voltage between the base and the emitter of the transistor Q opposite to the base-emitter voltage $V_{BE}$ of the load transistor Q when the load transistor Q is turned ON. In general, the constant current $I_{CS}$ may be 0.5 mA or higher. Taking a margin into consideration, the constant current $I_{CS}$ may be 0.5 mA.

The bias current source $CS_0$ always provides the constant current $I_{CS}$ to the load transistor Q to suppress the change of the base-emitter voltage $V_{BE}$, so that the voltage $V_\ell$ on the transfer line $\ell$ is not changed regardless of the change of the status of the load transistor Q, i.e., the change between the ON state and the OFF state, of the load transistor Q. Accordingly, the charging and discharging of the stray capacitor C are avoided, and generation of the distortion of the rising signal and the trailing signal is prevented.

As shown in Fig. 8b, the bias current source $CS_0$ can be provided at the transmission side IC chip CH1. Since the bias current source $CS_0$ is connected between the base and the emitter of the load transistor Q, the operation is same to that described above.

In Figs. 8a and 8b, by providing the bias current source $CS_0$, a DC level of the output signal $S_{OUT}$ can be made low than that of the interface circuit shown in Fig. 3, and thus the resistance $R_L$ of the load resistor R should be greater than that of the load resistor shown in Fig. 3. In addition, a current flowing through the load transistor Q may be increased, and a capacity of the load transistor Q may become larger than that of the transistor shown in Fig. 3. However, note that an amplitude of the output signal $S_{OUT}$, per se, is not changed, regardless of the provision of the bias current source $CS_0$.

Figures 9a and 9b show the characteristic curves of the interface circuits shown in Figs. 8a and 8b obtained by simulation. Figure 9a shows a rising characteristic. In Fig. 9a, curves $CV6_a$ to $CV6_d$ represent the rising characteristics corresponding to the change of the drive signal, i.e., the input signal $S_{IN}$, represented by curve DW, when the stray capacitances $C_S$ are 0.1 pF, 0.5 pF, 1.0 pF, and 5.0 pF. These curves $CV6_a$ to $CV6_d$ correspond to the curves $CV4_a$ to $CV4_d$ in Fig. 6a. Compared with these, as shown in Fig. 6a, the characteristics shown by the curves $CV4_a$ to $CV4_c$ when the stray capacitances are 0.1 pF, 0.5 pF, and 1.0 pF are greatly varied therebetween, but on the other hand, as shown in Fig. 9a, the characteristics shown by the curves $CV6_a$ to $CV6_c$ are not varied each other. This means that the transfer line $\ell$ in the interface circuit shown in Fig. 8a can install at a short distance or a long distance without any circuit adjustment. The characteristics shown by the curves $CV7_a$ to $CV7_c$ mean the same thing.

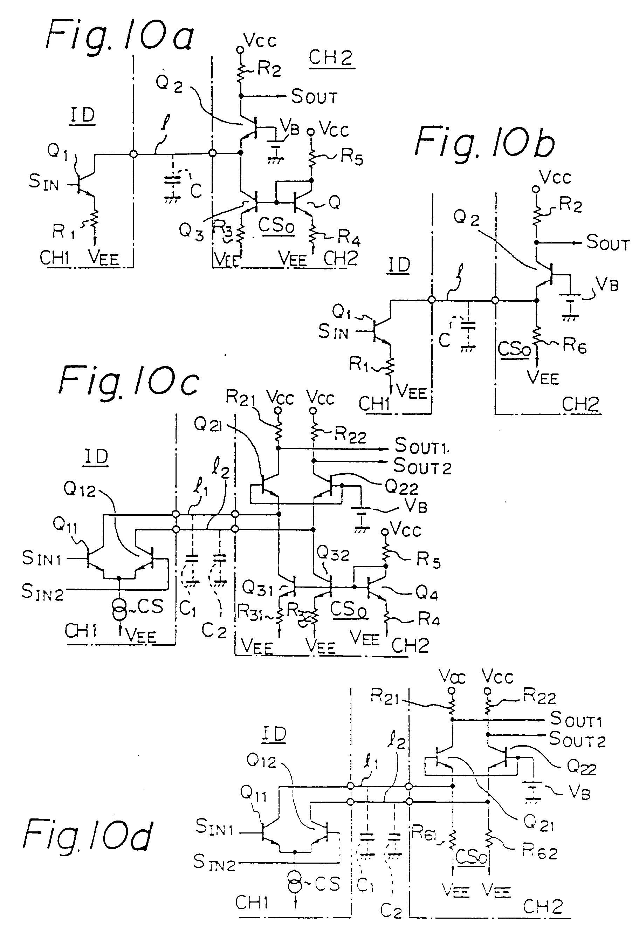

Figures 10a to 10d show circuit diagrams of an interface circuit.

The interface circuits shown in Figs. 10a and 10b are the open-collector type interface circuits corresponding to the interface circuit shown in Fig. 5a. In Fig. 10a, the bias current source $CS_0$ is formed by a current-mirror type current source composed of npn-type transistor $Q_3$ and $Q_4$, resistors $R_3$ and $R_4$, and a resistor $R_5$. The current-mirror type current source, per se, is well known. In Fig. 10b, the bias current source $CS_0$ is formed by a resistor $R_6$. The interface circuits shown in Figs. 10c and 10d are differential-operation and open-collector type interface circuits corresponding to the interface circuit shown in Fig. 5b. In Fig. 10c, the bias current source $CS_0$ is formed by a current-mirror type constant current source composed of npn-type transistor $Q_{31}$, $Q_{32}$ and $Q_4$, and resistors $R_{31}$, $R_{32}$, $R_4$ and $R_5$. In Fig. 10d, the bias current source $CS_0$ is formed by two resistors $R_{61}$ and $R_{62}$.

The interface circuits shown in Figs. 10a to 10d can be provided with the bias current source $CS_0$ at the transmission side IC chip CH1.

When the input signal $S_{IN}$ is a high frequency repetition signal, such as a clock signal, in the base-grounded interface circuit shown in Fig. 3, a wave form distortion may not occur, since a charge accumulated in the stray capacitor is not fully discharged, and the base emitter voltage $V_{BE}$ is not substantially changed. But, when the input signal $S_{IN}$ is a data signal which may be formed by continuous one's data or continuous zero's data, a wave form distortion can occur at a transient state where an end of the continuous one's data is followed by a first of the continuous zero's data, or vice versa.

In particular, such interface circuits are very useful when forming interfaces, such as an interface between circuits in a gate array integrated circuit chip wherein a wiring pattern capacitance is considerably large, and an interface between chips wherein a bonding pad capacitance can not be neglected.

According to the above interface circuits since the frequency characteristic and the wave response characteristic are not affected by the stray capacitor, a high speed data transmission can be achieved.

Second, a level shift circuit will be described.

In the case of a data processing at a high speed, a level shift of a DC bias level of a signal by a predetermined voltage is required. For example, in an amplification circuit, a DC level of an input signal can be shifted to a level equal to a reference voltage by using the level shift circuit.

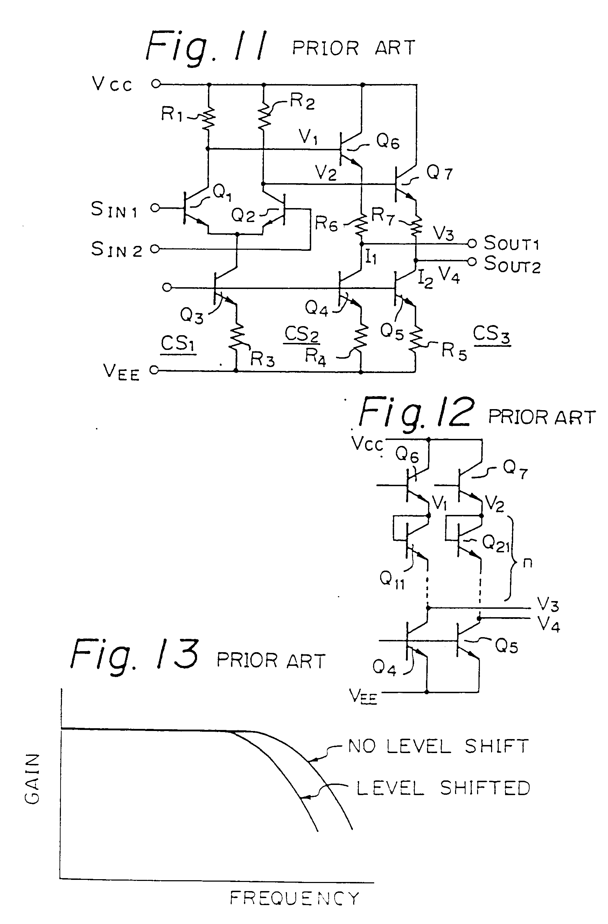

Figure 11 shows a prior art differential-operation type level shift circuit. In the drawing, the level shift circuit includes a pair of differential-operation transistors $Q_1$ and $Q_2$, a first current source $CS_1$ consisting of a transistor $Q_3$ and a resistor $R_3$, a second current source $CS_2$ consisting of a transistor $Q_4$ and a resistor $R_4$, a third current source $CS_3$ consisting of a transistor $Q_5$ and a resistor $R_5$, output emitter follower transistors $Q_6$ and $Q_7$, and resistors $R_1$, $R_2$, $R_6$ and $R_7$. Upon receipt of input signals $S_{IN1}$ and $S_{IN2}$ at bases of the transistors $Q_1$ and $Q_2$, a pair of differential-operated output voltages $V_1$ and $V_2$ are respectively extracted from points at which collectors of the transistors $Q_1$ and $Q_2$ and the load resistors $R_1$ and $R_2$ are commonly connected, and supplied to bases of the transistors $Q_6$ and $Q_7$. Output signals $S_{OUT1}$ and $S_{OUT2}$ having voltages $V_3$ and $V_4$, respectively, are output from points collectors of the transistors $Q_4$ and $Q_5$ and the resistors $R_5$ and $R_7$ are commonly connected. The voltages $V_1$ and $V_3$, and the voltage $V_2$ and $V_4$ have the following relationships:

$$V_1 = V_{BE} + I_1R_6 + V_3 \quad (9)$$
$$V_2 = V_{BE} + I_2R_7 + V_4 \quad (10)$$

where,

$V_{BE}$ is a base-emitter voltage of the transistors $Q_4$ and $Q_5$,

$R_6$ and $R_7$ are resistances of the resistors $R_5$ and $R_7$,

$I_1$ is a current passing through the transistor $Q_4$, and

$I_2$ is a current passing through the transistor $Q_5$.

Namely, the output voltages $V_3$ and $V_4$ are shifted from the voltage $V_1$ and $V_2$ by $(V_{BE} + I_1R_5)$ and $(V_{BE} + I_2R_7)$. In this level shift circuit, the levels to be shifted can be easily changed continuously by changing the currents $I_1$ and $I_2$ of the current sources $CS_2$ and $CS_3$.

Figure 12 shows a prior art diode-type level shift circuit. In the drawing, n-series connected transistors, for example, $Q_{11}$, each connected between a collector and a base and functioning as a diode, are connected between transistors $Q_6$ and $Q_4$. Similarly, n-series connected transistors, for example, $Q_{21}$, each connected between a collector and a base and functioning as a diode, are connected between transistors $Q_7$ and $Q_5$. In the drawing, the following relationships stand:

$$V_1 = (n + 1)V_{BE} + V_3 \quad (11)$$
$$V_2 = (n + 1)V_{BE} + V_4 \quad (12)$$

where,

$V_{BE}$ is a base-emitter voltage of the diode-functioning transistor.

Namely, by changing the number of the diode-changing transistors, a level shift voltage $(n+1)V_{BE}$ can be stepwisely changed.

Figure 13 shows a graph of frequency characteristics of the level shift circuits shown in Figs. 11 and 12. In the level shift circuit shown in Fig. 11, due to the resistors $R_6$ and $R_7$ at the emitter follower circuits and stray capacitors which can be connected to the emitter follower circuits, as shown in Fig. 13, the frequency characteristic is reduced, and accordingly, a wave response characteristic is reduced. As a result, the level shift circuit in Fig. 11 can not be applied to a high speed circuit. The level shift circuit shown in Fig. 12 has the same problem as that described above.

In general, in order to realize a high speed operation level shift circuit without a distortion of a wave form, several design techniques can be utilized, for example, reducing the resistances of the series-connected resistors $R_5$ and $R_7$, reducing capacitances of the stray capacitors, and arranging a circuit construction in which the stray capacitors are replaced by other portions directly affecting the characteristic. Nevertheless, these countermeasures are limited in practice.

Conversely, a circuit providing a bias current source $CS_0$ in addition to the cascode configuration as shown in Figs. 8a and 8b prevents a distortion of a wave form of a output signal and the reduction of a variety of characteristics, due to the stray capacitance. In this invention, the above feature is included to form a high speed level shift circuit without the reduction of the frequency characteristic and the wave response characteristic.

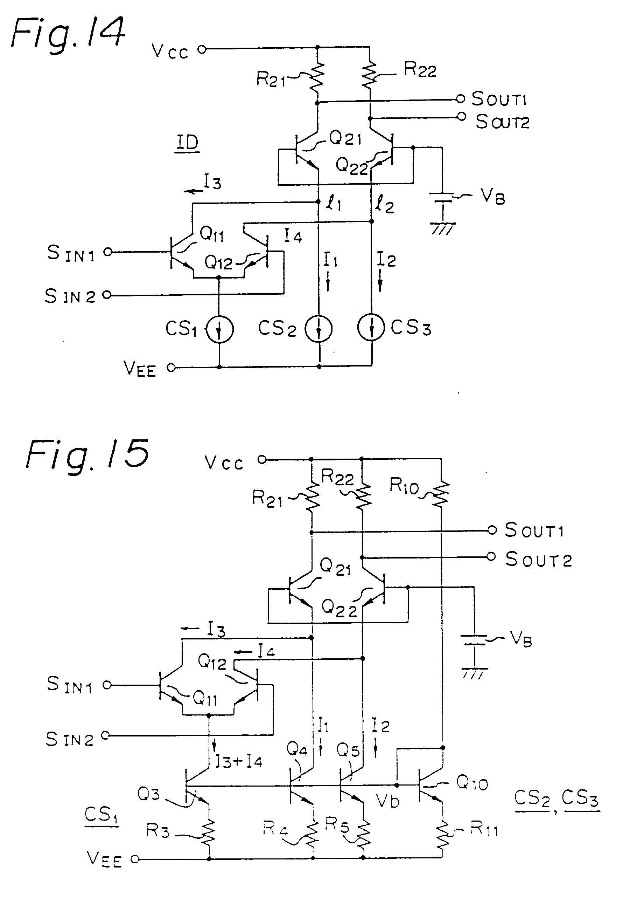

Figure 14 shows a principle circuit diagram of a level shift circuit.

The level shift circuit includes a pair of differential-operation transistors $Q_{11}$ and $Q_{12}$, and a constant current source $CS_1$ connected between collectors of the transistors $Q_{11}$ and $Q_{12}$ and a low voltage line $V_{EE}$ which may be ground. The level shift circuit also includes load resistors $R_{21}$ and $R_{22}$, load transistors $Q_{21}$ and $Q_{22}$, a bias voltage supply $V_B$, and level shift current sources $CS_2$ and $CS_3$.

The emitters of the transistors $Q_{11}$ and $Q_{12}$ are

grounded through the constant current source $CS_1$, collectors of the transistors $Q_{11}$ and $Q_{12}$ are connected to emitters of the transistors $Q_{21}$ and $Q_{22}$, and bases of the transistors $Q_{21}$ and $Q_{22}$ are grounded through the bias voltage supply $V_B$. Accordingly, the above circuit has a cascode configuration. In addition, the variable current sources $CS_2$ and $CS_2$ corresponding to the bias current source $CS_0$ shown in Fig. 8a are connected between the emitters of the transistors $Q_{21}$ and $Q_{22}$ and the low voltage line $V_{EE}$, which is ground.

A differential-operation pair circuit, corresponding to the current drive circuit ID in Fig. 8a, consisting of the transistors $Q_{11}$ and $Q_{12}$ and the constant current sources $CS_1$ receives voltage input signals $S_{IN1}$ and $S_{IN2}$, and changes to currents $I_3$ and $I_4$ flowing therethrough. The currents $I_3$ and $I_4$ are varied in response to the voltages of the input signals $S_{IN1}$ and $S_{IN2}$. The constant current source $CS_1$ supplies a current of a sum of $I_3$ and $I_4$. The above currents $I_3$ and $I_4$ are made flow through the load resistors $R_{21}$ and $R_{21}$, resulting in voltage drops $V_{21} = I_3 \cdot R_{21}$ and $V_{22} = I_4 \cdot R_{22}$ which are output signals $S_{OUT1}$ and $S_{OUT2}$. In addition, currents $I_1$ and $I_2$ supplied by the level shift current sources $CS_2$ and $CS_3$ are made flow through the load resistors $R_{21}$ and $R_{22}$, resulting in further voltage drops $V_{L1} = I_1 \cdot R_{21}$ and $V_{22} = I_2 \cdot R_{22}$. These voltage drops $V_{L1}$ and $V_{L2}$ are level-shifted values. Since the currents $I_1$ and $I_2$ can be changed by adjusting the current sources $CS_2$ and $CS_3$, the level shift voltages $V_{L1}$ and $V_{L2}$ can be continuously changed.

The basic condition of the interface circuits shown in Figs. 8a and 8b and Figs. 10a to 10d can be applied to the level shift circuit shown in Fig. 14, except for the variable level shift current sources $CS_2$ and $CS_3$. Therefore, the features of the interface circuit are maintained in the level shift circuit. A basic difference between the interface circuit and the level shift circuit is the provision of the constant bias current source $CS_0$ and the variable level shift current sources $CS_2$ and $CS_3$. However, if the level shift circuit can be used for shifting at a constant level, the current sources $CS_2$ and $CS_3$ can be formed as constant current sources.

Figure 15 shows a further circuit diagram of a level shift circuit;

In Fig. 15, the constant current source $CS_1$ is composed of an npn-transistor $Q_3$ and a resistor $R_3$, and supplies a current corresponding to $(I_3 + I_4)$. The current sources $CS_2$ and $CS_3$ are formed by a current-mirror type current source circuit consisting of npn-type transistors $Q_4$, $Q_5$, and $Q_{10}$, and resistors $R_4$, $R_5$, $R_{10}$, and $R_{11}$. The transistors $Q_4$ and $Q_5$ and the transistors $R_4$ and $R_5$ are defined to supply the current $I_1$ and $I_2$. In this circuit, the current sources $CS_2$ and $CS_3$ are constant current sources, and the level shift is fixed.

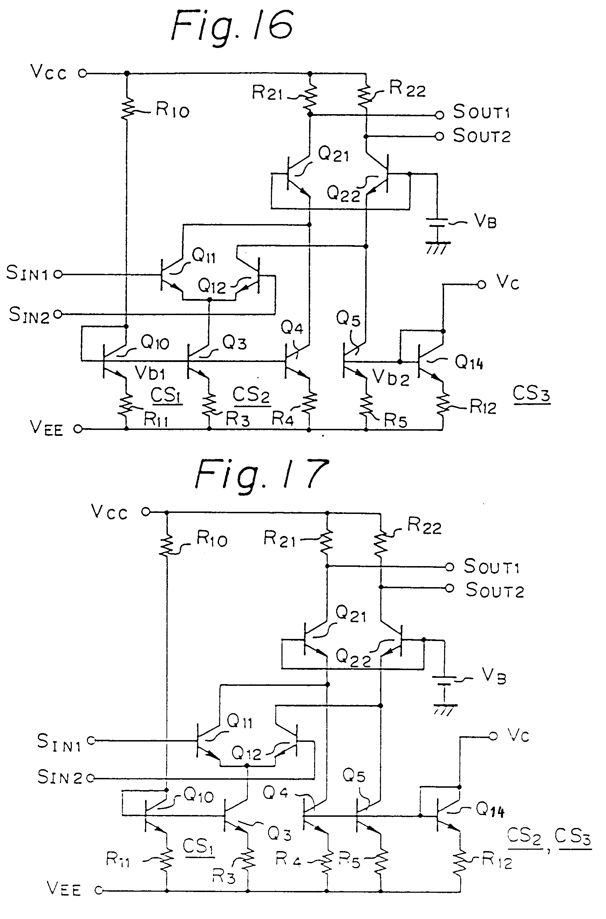

In Fig. 16 a first embodiment of a level shift circuit in accordance with the present invention is shown, in which the current source $CS_1$ consists of a transistor $Q_3$ and a resistor $R_3$, the current source $CS_2$ consists of a resistor $R_{10}$, a transistor $Q_{10}$, a resistor $R_{11}$, a transistor $Q_4$, and a resistor $R_4$, and the current source $CS_3$ consists of a transistors $Q_5$ and $Q_{14}$, and resistors $R_5$ and $R_{12}$. The current source $CS_2$ and the current source $CS_3$ are current-mirror type current sources. By changing a control voltage $V_C$ supplied to the current source $CS_3$, a level of an output signal $S_{OUT2}$ can be continuously changed. But, since the current source $CS_2$ is a constant current source, a level-shift of an output signal $S_{OUT1}$ is fixed.

The level shift circuit in accordance with the second embodiment of the present invention is shown in Fig. 17 and is a modification of the level shift circuit shown in Fig. 16. In the drawing the constant current source $CS_1$ is formed by a current-mirror type current source consisting of a resistor $R_{10}$, transistors $Q_{10}$ and $Q_3$, and resistors $R_{11}$ and $R_3$. The current sources $CS_2$ and $CS_3$ are formed by a variable current-mirror type current source consisting of transistors $Q_4$, $Q_5$, and $Q_{14}$, and resistors $R_4$, $R_5$ and $R_{12}$. By changing a control voltage $V_C$ supplied to the current sources $CS_2$ and $CS_3$, the levels of both of the output signals $S_{OUT1}$ and $S_{OUT2}$ can be continuously shifted.

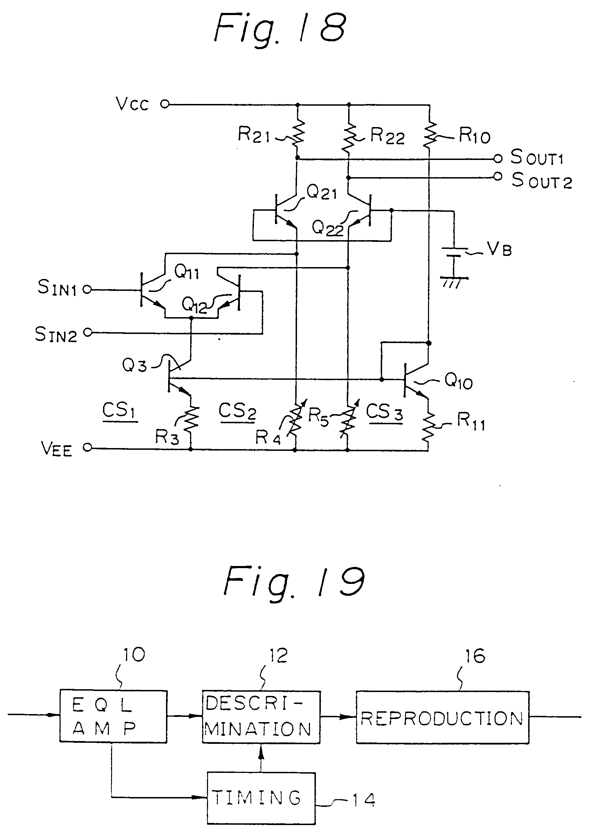

In Fig. 18, which shows a conventional device the constant current source $CS_1$ is formed by a current-mirror type current source consisting of transistors $Q_3$ and $Q_{10}$, and resistors $R_{10}$, $R_3$, and $R_{11}$. The current sources $CS_2$ and $CS_3$ are variable resistors $R_4$ and $R_5$. The levels of both of the output signals $S_{OUT1}$ and $S_{OUT2}$ can be freely shifted by adjusting the resistances of the resistors $R_4$ and $R_5$.

Third, a signal discrimination circuit will be described.

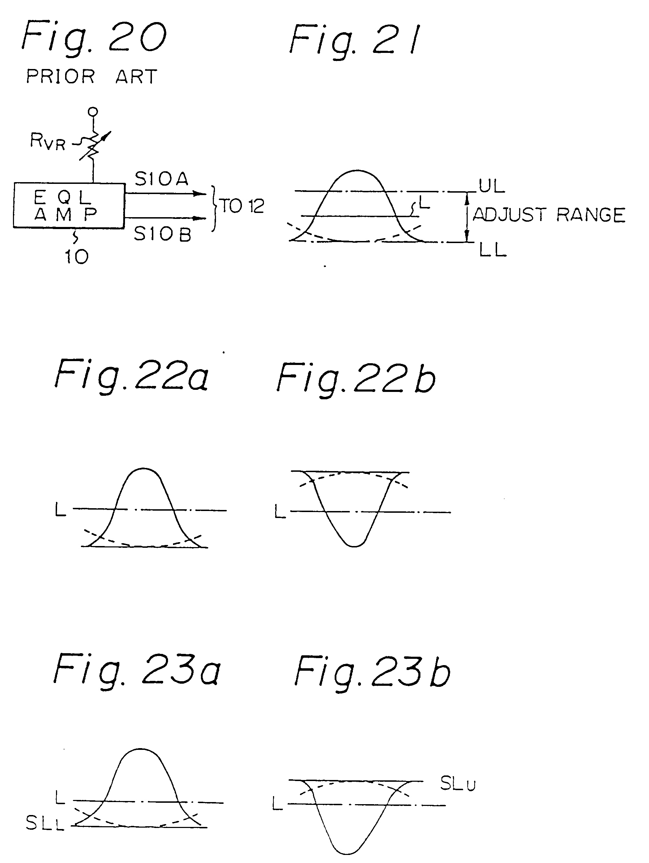

The signal discrimination circuit can be applied, for example, to a repeater in an optical data transmission system. In the repeater, as shown in Fig. 19, an optical to electrical (OE) converted signal is equalized and amplified at an equalizing amplifier 10, and a clock signal is extracted at a timing circuit 14. The equalized signal is discriminated by a timing signal from the timing circuit 14 at a signal discriminal circuit 12, and the discriminated signal is reproduced at a reproduction circuit 16. As shown in Fig. 20, a discriminating level can be varied by adjusting a variable resistor $R_{VR}$. The equalizing amplifier 10 outputs an equalized signal S10A and a discriminating threshold voltage signal S10B. As shown in Fig. 21, the equalized signal S10A, having a distorted eye-pattern by an optical shock and a shifted timing, is discriminated by a threshold level L at the discrimination circuit 12, and a high level signal is output when the equalized signal is higher than the threshold level L at a clock timing, and alternatively, a low level signal is output. In order to adjust the threshold level to a maximum level in response to variations, such as a drift of the circuit, or noise, the threshold level L is adjusted by the variable resistor $R_{VR}$, and the discrimination circuit 12 discriminates the equalized signal S10A by using the adjusted threshold level signal S10B.

In the optical transmission system, a very high speed signal processing is required. Such a high speed signal processing requires an improvement of a wave form response and a prevention of cross-talk. The improvement and the prevention, in general, require to reduce a gain at the equalizing amplifier, and to reduce an amplitude of the equalized signal. This amplitude reduction lowers the discrimination sensitivity.

In general, when an amplitude is small, and thus the discrimination sensitivity is low, the differential-operation type discrimination is preferable, but is difficult to adjust the discrimination level. Namely, since a normal polarity signal shown in Fig. 22a and an inverted polarity signal shown in Fig. 22b are used in the differential-operation discrimination, the discrimination threshold level L is determined at a center level. In the optical transmission system, a center of the eye-pattern tends to be shifted to a low level, and a free level shifting is required in the discrimination used by the differential-operation type circuit.

In addition, the differential-operation type circuit has an advantage in that a deadband of the discrimination defined by a low limit LL and a upper limit UL shown in Fig. 21 is reduced by a half.

A signal discrimination circuit can be formed by a differential-operation type circuit, and operates at a high speed, has a high discrimination sensitivity, and can adjust the discrimination threshold level.

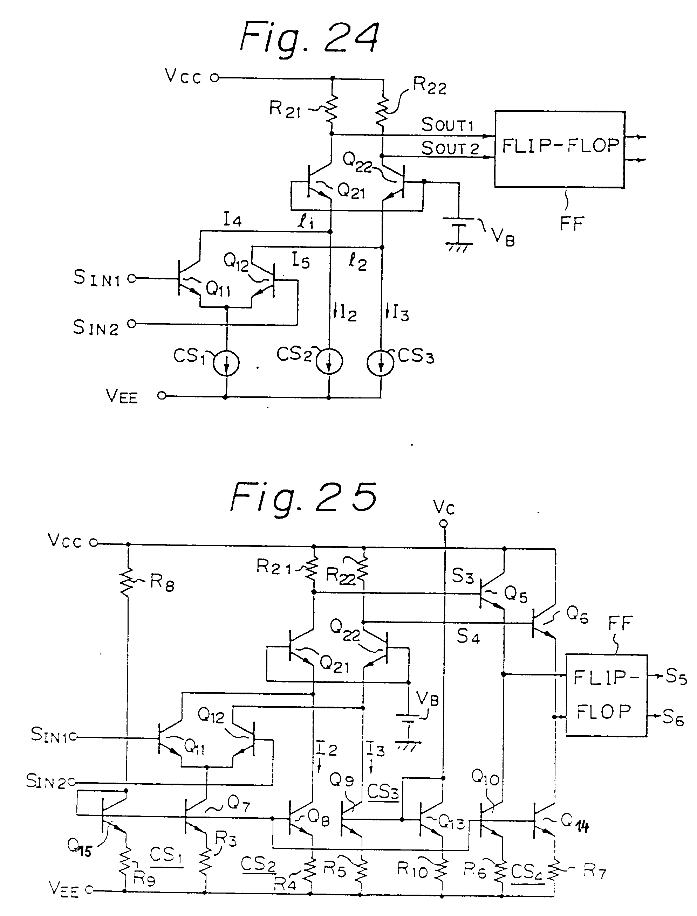

Figure 24 shows a principle of a signal discrimination circuit.

A basic circuit configuration of the signal discrimination circuit shown in Fig. 24 is similar to the level shift circuit shown in Fig. 14, except that a flip-flop FF is provided. Accordingly, a description of the basic circuit configuration and operation thereof is omitted.

Currents $I_4$ and $I_5$, which are made to flow through load resistors $R_{21}$ and $R_{22}$, load transistors $Q_{21}$ and $Q_{22}$, a pair of differential-operation transistors $Q_{11}$ and $Q_{12}$ and a current source $CS_1$, respectively, are varied in response to input signals $S_{IN1}$ and $S_{IN2}$. These currents $I_4$ and $I_5$ generate voltage drops defined by $(R_{21} I_4)$ and $(R_{22} I_5)$ at the load resistors $R_{21}$ and $R_{22}$. In addition, currents $I_2$ and $I_3$, which respectively flow through the load resistors $R_{21}$ and $R_{22}$, the load transistors $Q_{21}$ and $Q_{22}$, and current sources $CS_2$ and $CS_3$, are defined by only the current sources $CS_2$ and $CS_3$ and generate voltage drops defined by $(R_{21} I_2)$ and $(R_{22} I_3)$. These voltage drops $(R_{21} I_2)$ and $(R_{22} I_3)$ indicate shift levels. Referring to Figs. 23a and 23b, a level $SL_L$ or a level $SL_U$ is shifted by $(R_{21} I_2 - R_{22} I_3)/2$ from the discrimination threshold level L. The level shifted output signals $S_{OUT1}$ and $S_{OUT2}$ are output to the flip-flop FF.

The current sources $CS_2$ and/or $CS_3$ are formed to supply variable currents $I_2$ and $I_3$ in response to a level shift value.

In the signal discrimination circuit shown in Fig. 24, all of the features of the level shift circuit shown in Fig. 14 are maintained.

Figure 25 shows a specific circuit diagram of an embodiment of the signal discrimination circuit in accordance with the present invention. In Fig. 25, emitter-follower transistors $Q_5$ and $Q_6$ are provided to output signals $S_3$ and $S_4$ therethrough. The constant current source $CS_1$ is formed by a current-mirror type current source circuit consisting of transistors $Q_{15}$ and $Q_7$ and resistors $R_8$, $R_9$ and $R_3$. The current source $CS_2$ is formed by a current-mirror type current source circuit consisting of a transistor $Q_8$, a resistor $R_4$, the common resistors $R_8$ and $R_9$, and the common transistor $Q_{15}$. The current source $CS_3$ is formed by a current-mirror type current source circuit consisting of transistors $Q_9$ and $Q_{13}$ and resistors $R_8$ and $R_{10}$. A current source $CS_4$ for the emitter-follower transistors $Q_5$ and $Q_6$ is formed by a current-mirror type current source circuit consisting of transistors $Q_{10}$ and $Q_{14}$, resistors $R_8$ and $R_7$, the common resistor $R_8$, the common transistor $Q_{15}$ and the common resistor $R_9$.

In the drawing, the current source $CS_3$ can change the current $I_3$ by adjusting a control voltage $V_C$, and can shift the level of the signal $S_4$. The current source $CS_3$ supplies a constant current $I_2$, and accordingly, the shift level of the signal $S_3$ is constant. Figures 23a and 23b show the level shift by the circuit shown in Fig. 25, and the signal discrimination therefor.

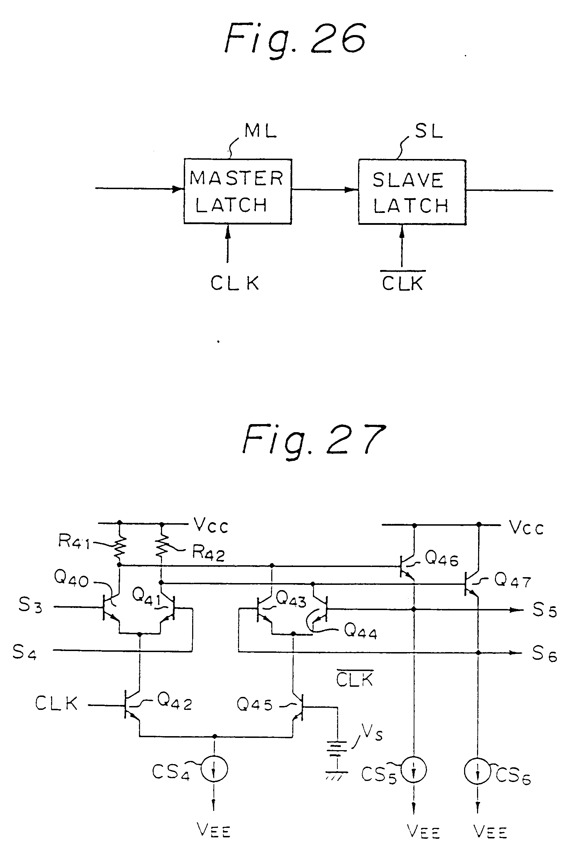

Figure 26 shows a block diagram of an embodiment of the flip-flop FF shown in Fig. 24. The flip-flop FF includes a master latch circuit ML driven, by a clock CLK and a slave latch circuit SL driven by an inverted clock CLK.

Figure 27 shows a specific circuit diagram of the flip-flop FF shown in Fig. 26. In the drawing, reference $V_S$ denotes a reference voltage supply, $CS_4$ to $CS_6$ denote current sources. The operation will be briefly described. When the signal $S_3$ is higher than the signal $S_4$, and when the clock CLK is at a high level higher than a voltage from the reference voltage supply $V_S$, a transistor $Q_{40}$ is turned ON, a transistor $Q_{41}$ is turned OFF, a transistor $Q_{46}$ is turned OFF and a transistor $Q_{47}$ is turned ON, thus outputting a signal $S_5$ having a low level and a signal $S_6$ having a high level. Also, a transistor $Q_{43}$ is turned ON, a transistor $Q_{44}$ is turned OFF, and a transistor $Q_{45}$ is turned OFF. When the clock CLK becomes low level, the transistor $Q_{42}$ is turned OFF, the transistor $Q_{45}$ is turned ON, the transistor $Q_{43}$ is turned ON, and the transistor $Q_{44}$ is turned OFF, and thus the signal $S_5$ is maintained at a high level and the signal $S_6$ at a low level. That is, a latch function is achieved. The above latched statuses are updated in response to the levels of the input

signals $S_3$ and $S_4$ when the clock CLK becomes high level. Accordingly, the flip-flop FF shown in Fig. 27 functions as a discrimination circuit which reads data in response to the levels of the input signals $S_3$ and $S_4$ at a change time of the clock CLK, with a narrow pulse width of the clock CLK.

Referring to Fig. 25, since the level shift of the signal $S_3$ is constant and the level of the signal $S_4$ is shifted, the discrimination threshold level L is shifted by a half (1/2) of the level shift of the signal $S_4$. Also, the dead band of the discrimination shown in Fig. 21 is narrowed by a half.

Referring to Figs. 19, 20 and 25, the signals S10A and S10B correspond to the input signals $S_{IN1}$ and $S_{IN2}$, and the circuit shown in Fig. 25 including the flip-flop FF corresponds to the signal discrimination circuit 12. The clock CLK in Fig. 27 is supplied from the timing circuit 14 shown in Fig. 19.

As described above, the signal discrimination circuit of the present invention is formed by a combination of the level shift circuit, which is differential-operated and can shift the levels of the differential-input signals $S_{IN1}$ and $S_{IN2}$, and a latch circuit, such as the flip-flop FF, latching the level-shifted output signals $S_{OUT1}$ and $S_{OUT2}$. The signal discrimination circuit of the present invention can adjust the discrimination threshold level L and has a narrow dead band. The narrow dead band brings a reduction of an amplitude of the equalized signal, resulting in a prevention of cross-talk. In addition, since all of the features of the level shift circuit shown in Fig. 14 are maintained, the signal discrimination circuit of the present invention can operate at a high speed will improving the frequency characteristic and the wave form response characteristic. In particular, the signal discrimination circuit is preferably used for discriminating the OE converted signal because the free level shift is effective for discriminating a center eye-pattern lowered due to an optical shock.

Fourth, a signal distribution circuit will be described.

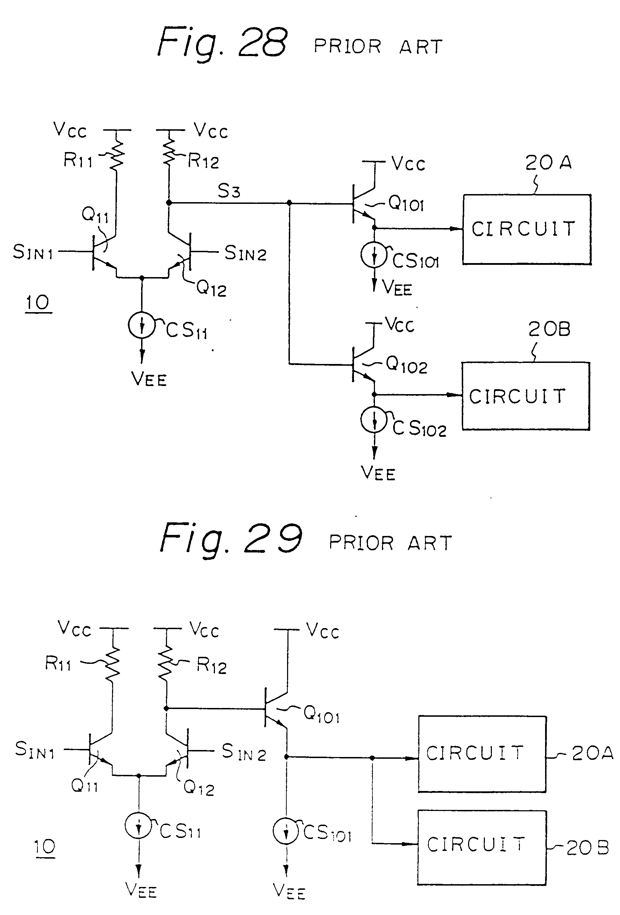

Figure 28 shows a prior art signal distribution circuit. In the drawing, a signal sending circuit 10 is a differential-operation pair type circuit consisting of resistors $R_{51}$ and $R_{52}$, transistors $Q_{51}$ and $Q_{52}$ and a constant current source $CS_{51}$. Two parallel-connected emitter-follower circuits, which consist of a transistor $Q_{101}$ and a constant current source $CS_{101}$, and a transistor $Q_{102}$ and a constant current source $CS_{102}$, respectively, are connected to a collector of the transistor $Q_{52}$. Two circuits 20A and 20B, which receive distributed signals follow the emitter-follower circuits. When receipt of two input signals $S_{IN1}$ and $S_{IN2}$, one of which may be a reference signal, a difference between the two input signals $S_{IN1}$ and $S_{IN2}$ is amplified and output as an output signal $S_3$. The output signal $S_3$ is supplied to bases of the transistors $Q_{101}$ and $Q_{102}$, and output signals, each of which is lowered by a base-emitter voltage $V_{BE}$ of each of the transistors $Q_{101}$ and $Q_{102}$, are supplied to the circuits 20A and 20B.

In Fig. 28, since the base-emitter capacitors (not shown) are connected to the resistor $R_{52}$ in parallel, a frequency characteristic of the signal distribution circuit is distorted. In addition, the input impedance of the circuits 20A and 20B adversely affects a voltage drop at the resistor $R_{52}$. As a result, the signal distribution circuit does not have sufficient fan-outs.

Figure 29 also shows a prior art signal distribution circuit. In the drawing, a single emitter-follower circuit consisting of the transistor $Q_{101}$ and the constant current source $CS_{101}$ is provided to supply two distributed signals to the circuits 20A and 20B. Since the input impedance of the circuits 20A and 20B are connected to an output terminal of the emitter-follower transistor $Q_{101}$, the frequency characteristic often may be fluctuated. In addition, the mutual status change of the circuits 20A and 20B adversely affects the signal distribution circuit. Also, this signal distribution circuit does not provide sufficient fan-outs.

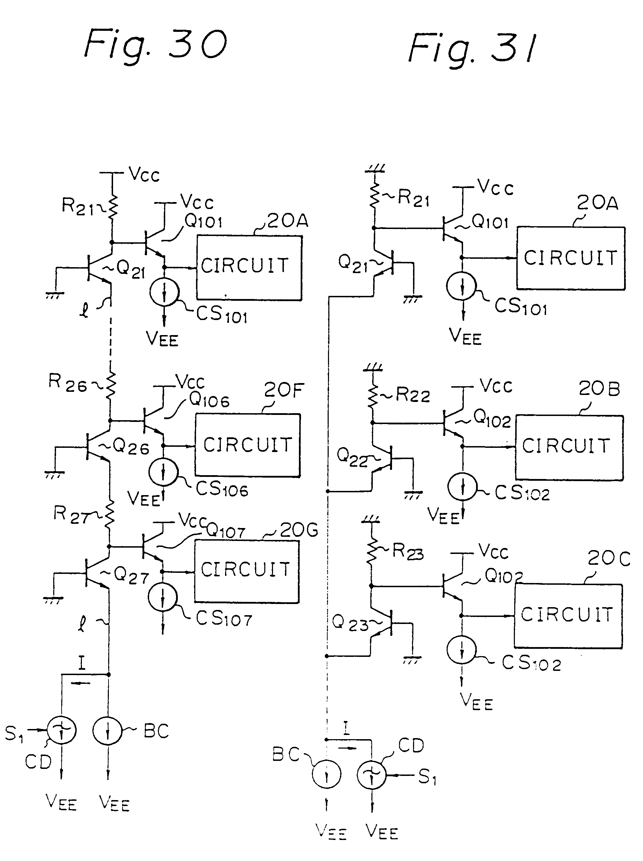

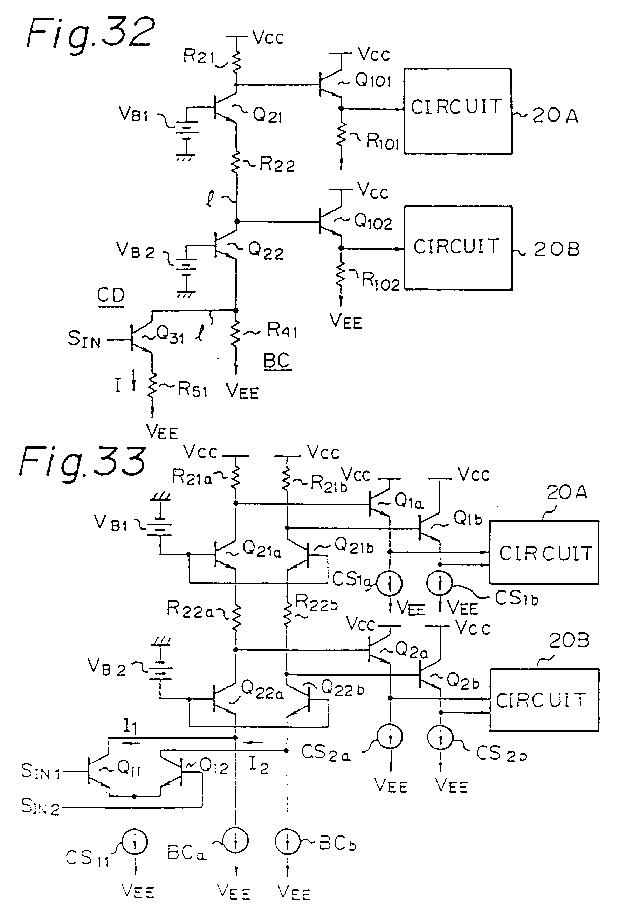

Figures 30 and 31 are circuit diagrams showing the principle of a signal distribution circuit.

The signal distribution circuit shown in Fig. 30 includes a current drive source ID having at least one transistor, an emitter of which is operatively grounded and a base of which receives an input signal $S_{IN}$, and series-connected base-grounded transistor circuits, for example, a base-grounded transistor circuit composed of a base-grounded transistor $Q_{21}$ and a resistor $R_{21}$. An emitter of each base-grounded transistor circuit is operatively connected to a collector of the transistor in the current drive source ID. Accordingly, the above circuit configuration is formed as a cascode configuration. In addition, a bias current source BC is connected between each emitter of the base-grounded transistor, for example, $Q_{27}$ and ground.

In addition, as an option, a plurality of emitter-follower circuits, each, for example, an emitter-follower circuit composed of an emitter-follower transistor $Q_{101}$ and a current source $CS_{101}$, can be connected to collectors of the base-grounded transistors. The circuits 20A to 20G are also connected to the emitter-follower circuits.

The signal distribution circuit shown in Fig. 30 changes the voltage input signal $S_{IN}$ to a current signal I passing through the series-connected base-grounded transistor circuits. Each voltage drop generated at each load resistor, for example, $R_{21}$, is supplied to the base of a corresponding emitter-follower transistor, for example, $Q_{101}$, to distribute the input signal $S_{IN}$.

In the drawing, since the emitter-follower circuits and the circuits 20A to 20G do not distribute the signals, the frequency characteristic is not distorted and the adverse affect due to the circuits 20A to 20G is avoided. In addition, the load resistors are separated by the base-grounded transistors, and thus the frequency characteristic is not adversely affected by the stray capacitors. Furthermore, by providing the bias current source BC, the adverse affect due the stray capacitance superimposed on the voltage of the transfer lines $\ell$ is fully eliminated. As a result, the signal distribution circuit shown in Fig. 30 operates at a high speed without a distortion of the frequency characteristic and the wave form response characteristic, and can provide many fan-outs regardless of the superimposition of the stray capacitance.

The signal distribution circuit shown in Fig. 31 includes the current drive source ID, parallel-connected base-grounded transistor circuits, and the bias current source BC. Optionally, a plurality of emitter-follower circuits and the circuits 20A to 20C are provided. The operation of the signal distribution circuit is similar to that of the signal distribution circuit shown in Fig. 30. The features of the signal distribution circuit shown in Fig. 31 are also similar to those of the signal distribution circuit shown in Fig. 30.

Comparing the signal distribution circuits shown in Figs. 30 and 31, in the signal distribution circuit shown in Fig. 30, a high voltage $V_{CC}$ is higher than that of the signal distribution circuit shown in Fig. 31, and the amplitudes of the distributed signals are the same. Conversely, in the signal distribution circuit shown in Fig. 31, each amplitude of the distributed signals is 1/n, where n represents the number of base-grounded transistor circuits.

Figures 32 to 37 show circuit diagrams of the signal distribution circuits shown in Figs. 30 and 31.

The signal distribution circuits shown in Figs. 32 and 33 correspond to the signal distribution circuit shown in Fig. 30. The bases of base-grounded transistors $Q_{21}$, $Q_{22}$, $Q_{21a}$, $Q_{21b}$, $Q_{22a}$ and $Q_{22b}$ are grounded through bias voltage supply circuits $V_{B1}$ and $V_{B2}$. Emitters of transistors $Q_{31}$, $Q_{11}$, and $Q_{12}$ are grounded through a resistor $R_{51}$ functioning as the current source and a current source $CS_{11}$. In Fig. 32, the bias current source BC is formed by a resistor $R_{41}$. Since the signal distribution circuit shown in Fig. 33 is differentially operated, two bias current sources $BC_a$ and $BC_b$ are provided.

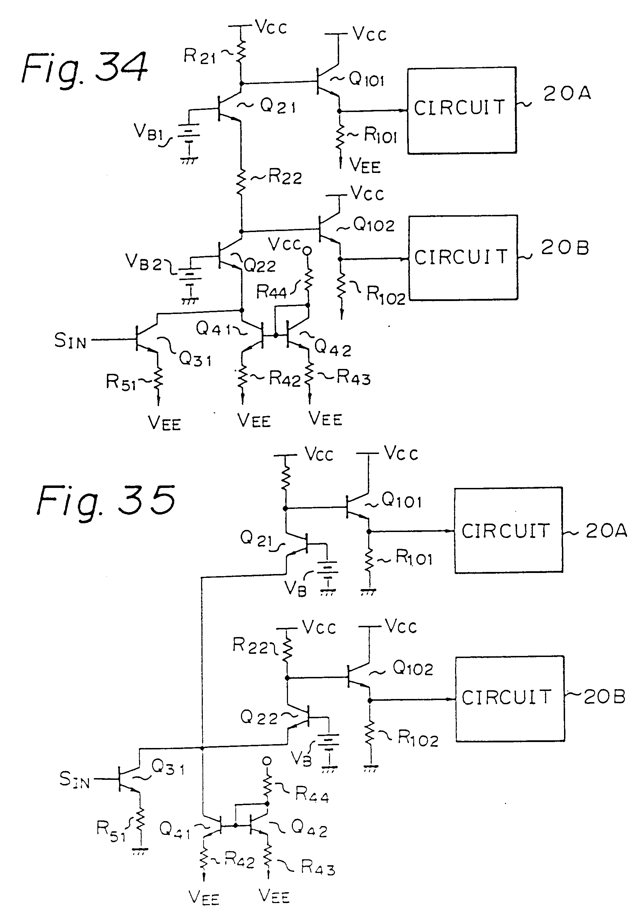

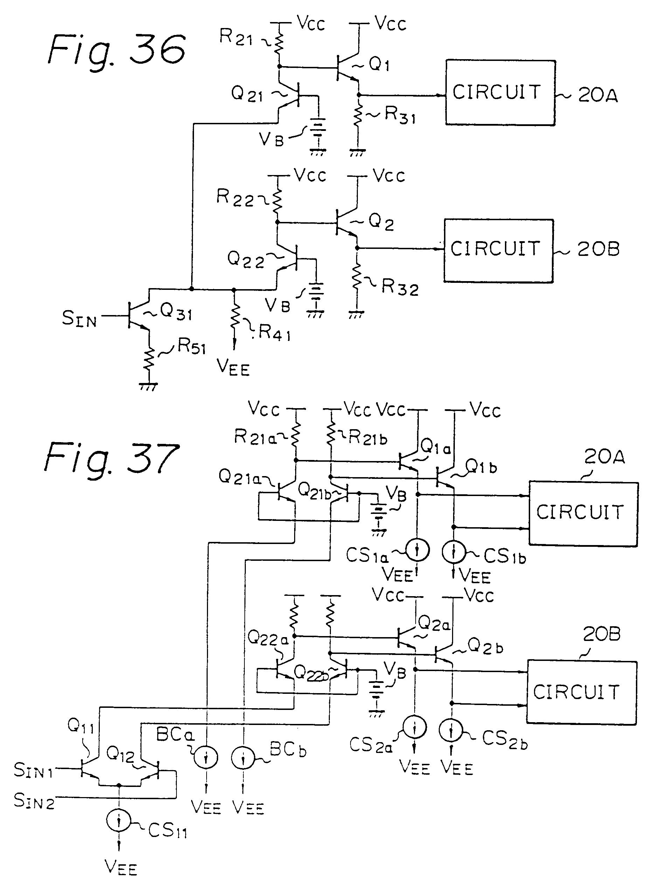

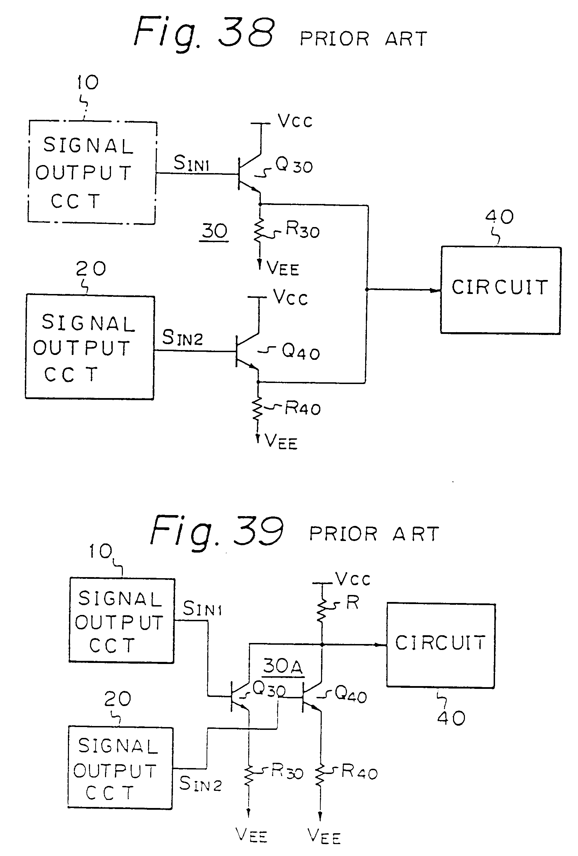

The signal distribution circuits shown in Figs. 36 to 37 correspond to the signal distribution circuit shown in Fig. 31. In Figs. 34 and 35, the bias current source BC is formed by a current-mirror type current source circuit. The signal distribution circuit shown in Fig. 37 is differentially operated.

A signal synthesization circuit will be described.

Figures 38 and 39 show prior art signal synthesization circuits. The operation of these signal synthesization circuits is well known, and thus a description thereof is omitted. In the signal synthesization circuit shown in Fig. 38, emitter-follower outputs of transistors $Q_{30}$ and $Q_{40}$ are connected to a circuit 40. The signal synthesization circuit shown in Fig. 38 suffers from the same defects as those of the signal distribution shown in Fig. 29. Also, the signal synthesization circuit shown in Fig. 39 suffers from defects similar to those of the signal distribution circuit shown in Fig. 28, since base-collector capacitors of transistors $Q_{30}$ and $Q_{40}$ are connected to a load resistor R in parallel.

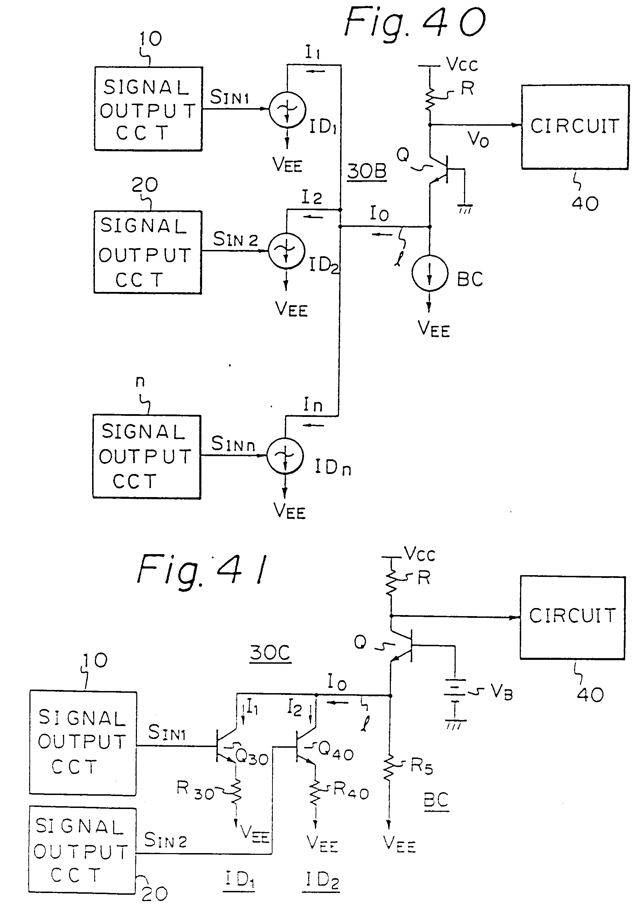

Figure 40 shows a circuit diagram showing the principle of a signal synthesization circuit. The signal synthesization circuit includes a plurality current drive sources $ID_1$ to $ID_n$ provided in correspondance to the number of input signals $S_{IN1}$ to $S_{INn}$ to be synthesized, a base-grounded transistor Q, a load resistor R, and a bias current source BC. Each current drive source ID includes a transistor, an emitter thereof being operatively grounded, and a base thereof receiving the input signal $S_{IN}$. As is apparent, the signal synthesization circuit is basically formed by a combination of the cascode configuration circuit and the current source BC.

In the Fig. 40, the current drive circuits $ID_1$ to $ID_n$ change the voltage input signals $S_{IN1}$ to $S_{INn}$ to current signals $I_1$ to $I_n$, and the current signals $I_1$ to $I_n$ are synthesized at a common connected point as $I_0 = I_1 + I_2 + ... + I_n$. The synthesized current signal $I_0$ is changed to a voltage $V_0$ at the load resistor R. This voltage $V_0$ is supplied to a circuit 40.

Since the base-grounded transistor Q separates a connection between the current drive sources $ID_1$ to $ID_n$ and the load resistor R, the adverse affect due to a stray capacitance on the current drive sources $ID_1$ to $ID_n$ is prevented. In addition, since output impedances of the current drive sources $ID_1$ to $ID_n$ are high, a mutual interface between the current drive sources $ID_1$ to $ID_n$ is substantially avoided. Furthermore, the provision of the bias current source BC eliminates the adverse affect due to the stray capacitor connected to the transfer line $\ell$. As a result, the signal synthesization circuit shown in Fig. 40 provide many fan-ins, and operates at a high speed without a distortion of the frequency characteristic.

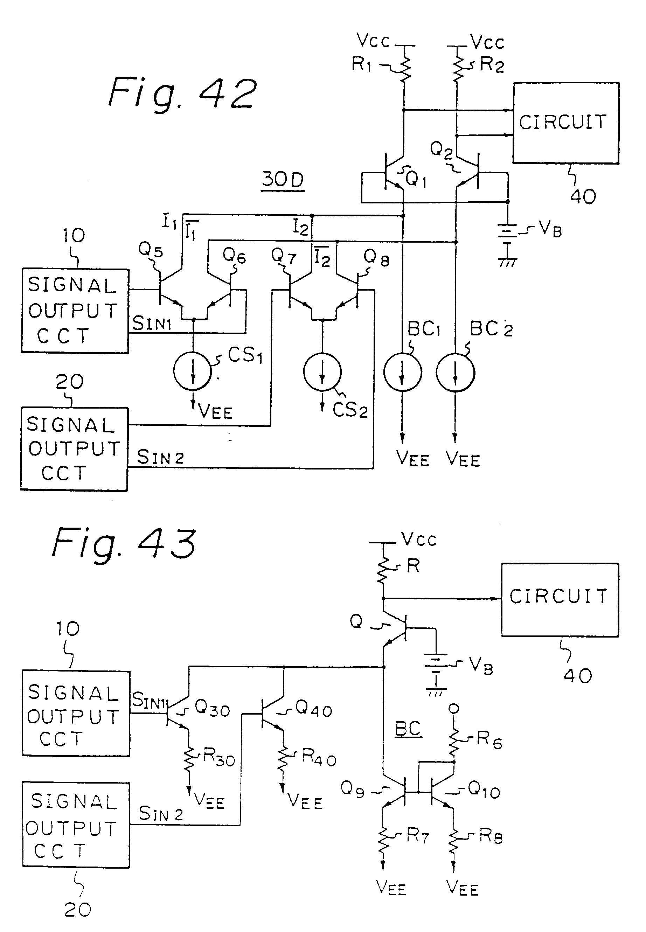

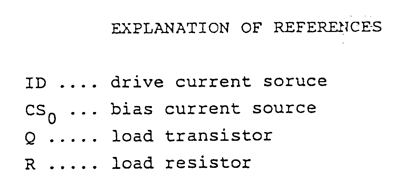

Figures 41 and 42 show further signal synthesization circuits. Figure 43 shows circuit diagram of an embodiment of the signal synthesization circuit in accordance with present invention. The configuration and the operation of these signal synthesization circuits are apparent from the above description.

In particular, a signal synthesization circuit of the present invention overcomes the above defects of the load resistor commonly used type signal synthesization circuit shown in Fig. 39.

## Claims

1. A level shift circuit comprising:

a current drive circuit (ID) including at least one input transistor ($Q_{11}$,$Q_{12}$;$Q_{30}$,$Q_{40}$), the emitter thereof being operatively grounded and a base thereof receiving a respective input signal $(S_{IN1};S_{IN2})$;

a load transistor circuit including at least one load transistor $(Q; Q_{21}; Q_{22})$, the base of each load transistor being operatively grounded, the emitter of each load transistor being connected to the collector of a respective input transistor $(Q_{11},Q_{12},Q_{30},Q_{40})$;

a bias current source connected between said emitter of said load transistor and ground, a respective current generated by said bias current source being supplied to each load transistor to maintain a forward base emitter voltage (VBE) of each load transistor; and

a load resistor circuit including at least one load resistor $(R; R_{21}, R_{22})$ connected between the collector of a respective load transistor $(Q;Q_{21},Q_{22})$ in said load transistor circuit and a power supply voltage $(V_{CC})$, an output signal $(S_{OUT1}, S_{OUT2})$ being provided at the collector of each load transistor;

characterized in that

said bias current source comprises a current mirror circuit $(CS_2, CS_3)$ for each current to be provided, at least one of said current mirror circuits being connected to a control voltage source $(V_c)$ to shift the level of said output signal by a value defined by the control voltage source $(V_c)$.

2. A level shift circuit according to claim 1, characterized in that said current drive circuit (ID) includes first and second input transistors $(Q_{11}$ and $Q_{12})$ connected in parallel to differentially operate in response to two input signals $(S_{IN1}$ and $S_{IN2})$ connected to bases thereof and a current source $(CS_1)$ connected between emitters of said first and second input transistors $(Q_{11},Q_{12})$ and ground,

said load transistor circuit includes first and second load transistors $(Q_{21}$ and $Q_{22})$, the emitter of said first load transistor being connected to the collector of said first input transistor, the emitter of said second load transistor being connected to the collector of said second input transistor and bases of said first and second load transistors being commonly connected and operatively grounded,

said load resistor includes

two load resistors $(R_{21}$ and $R_{22})$ connected to collectors of said first and second load transistors, respectively, to output two output signals $(S_{OUT1}$ and $S_{OUT2})$ from points at which said collectors and said load resistors are commonly connected, and

said current-mirror circuit includes first to third current source transistors $(Q_4, Q_5$ and $Q_{14};Q_8, Q_9$ and $Q_{13})$ connected in parallel, collectors of said first and second current source tran-

sistors $(Q_4,Q_5;Q_8,Q_9)$ being respectively connected to said emitters of said first and second load transistors, the control voltage source $(V_C)$ being connected to a collector of said third current source transistor $(Q_{14})$, the collector of said third current source transistor $(Q_{14};Q_{13})$ being connected to a base thereof which is commonly connected to the base of said second current source transistor $(Q_5;Q_9)$ and second to fourth current source resistors $(R_4, R_5$ and $R_{12};R_4,R_5$ and $R_{10})$ respectively connected between emitters of said first to third current source transistors and ground.

3. A level shift circuit according to claim 1, characterized in that said current drive circuit (ID) includes first and second input transistors $(Q_{11}$ and $Q_{12})$ connected in parallel to differentially operate in response to two input signals $(S_{IN1}$ and $S_{IN2})$ connected to bases thereof and a current source $(CS_1)$ connected between emitters of said first and second input transistors and ground,

said load transistor circuit includes first and second load transistors $(Q_{21}$ and $Q_{22})$, the emitter of said first load transistor being connected to the collector of said first input transistor, the emitter of said second load transistor being connected to the collector of said second input transistor and bases of said first and second load transistors being commonly connected and operatively grounded,

said load resistor includes

two load resistors $(R_{21}$ and $R_{22})$ connected to collectors of said first and second load transistors, respectively, to output two output signals $(S_{OUT1}$ and $S_{OUT2})$ from points at which said collectors and said load resistors are commonly connected, and

said current-mirror circuit includes first to third current source transistors $(Q_4, Q_5$ and $Q_{14})$, connected in parallel, collectors of said first and second current source transistors $(Q_4,Q_5)$ being respectively connected to said emitters of said first and second load transistors, the control voltage source $(V_C)$ being connected to a collector of said third current source transistor $(Q_{14})$, the collector of said third current source transistor being connected to a base thereof which is commonly connected to bases of said first and second current source transistors and second to fourth current source resistors $(R_4, R_5$ and $R_{12})$ are respectively connected between emitters of said first to third current source transistors and ground.

4. A level shift circuit according to claim 2, characterized in that a latch circuit (FF) is connected with its inputs to said load resistor circuit.

5. A level shift circuit according to claim 1,
characterized in that
said current drive circuit (ID) includes first and second input transistors ($Q_{11}$ and $Q_{12}$) connected in parallel to differentially operate in response to two input signals ($S_{IN1}$ and $S_{IN2}$) connected to bases thereof and a current source ($CS_1$) connected between emitters of said first and second input transistors ($Q_{11}$, $Q_{12}$) and ground,

said load transistor circuit includes first and second load transistors ($Q_{21}$ and $Q_{22}$), the emitter of said first load transistor being connected to the collector of said first input transistor, the emitter of said second load transistor being connected to the collector of said second input transistor and bases of said first and second load transistors being commonly connected and operatively grounded,

said load resistor circuit includes two load resistors ($R_{21}$ and $R_{22}$) connected to collectors of said first and second load transistors, respectively, to output two output signals ($S_{OUT1}$ and $S_{OUT2}$) from points at which said collectors and said load resistors are commonly connected, and

said bias current source includes the first and a second current mirror circuit ($CS_2$, $CS_3$) connected to said first and second load transistors, respectively.

6. A level shift circuit according to claim 5, characterized in that said first current-mirror circuit is connected to the control voltage source ($V_C$) to change a current supplied therefrom.

7. A level shift circuit according to claim 5, characterized in that said second current-mirror circuit is connected to the control voltage source ($V_C$) to change a current supplied therefrom.

8. A level shift circuit according to claim 1, characterized in that a plurality of said current drive circuits ($ID_1$ to $ID_n$) are connected in parallel, each current drive circuit receiving a said input signal ($S_{IN}$) to be synthesized, said bias current source and said emitter of said at least one load transistor (Q) in said load transistor circuit are connected to the commonly connected collectors of said parallel current drive circuits.

9. A level shift circuit according to claim 4, characterized in that said latch circuit (FF) includes a master latch circuit (ML) driven by a clock (CLK) and a slave latch circuit (SL) driven by an inverted clock (CLK).

10. A level shift circuit according to claim 9, characterized in that said master latch circuit (ML) comprises:

prises:
a first pair of emitter follower transistors (Q40, Q41) connected in parallel, having their bases connected to said load resistor circuit, their collectors connected to a power supply voltage ($V_{cc}$) via respective load resistors ($R_{41}$, $R_{42}$), and their emitters connected to a transistor ($Q_{42}$) which receives said clock (CLK) at its base; and
a second pair of emitter follower transistors ($Q_{43}$, $Q_{44}$) connected in parallel, having their bases connected to the respective collectors of the first pair of emitter follower transistors ($Q_{40}$, $Q_{41}$) and having their emitters connected to a transistor ($Q_{45}$) which receives a reference voltage ($V_S$) at its base;
wherein the emitters of said transistors ($Q_{42}$, $Q_{45}$) are connected to a constant current source ($CS_4$).

**Patentansprüche**

1. Pegelverschiebschaltung mit:
einer Stromantriebsschaltung (ID) einschließlich von zumindest einem Eingabetransistor ($Q_{11}$, $Q_{12}$; $Q_{30}$, $Q_{40}$), wobei der Emitter davon betriebsmäßig auf Masse gelegt ist und eine Basis davon ein jeweiliges Eingabesignal ($S_{IN1}$; $S_{IN2}$) empfängt;
einer Lasttransistorschaltung einschließlich von zumindest einem Lasttransistor (Q; $Q_{21}$; $Q_{22}$), wobei die Basis von jedem Lasttransistor betriebsmäßig auf Masse liegt und der Emitter von jedem Lasttransistor verbunden ist mit dem Kollektor eines jeweiligen Eingabetransistors ($Q_{11}$, $Q_{12}$; $Q_{30}$, $Q_{40}$);
einer Vorspannungsstromquelle, die angeschlossen ist zwischen dem Emitter des Lasttransistors und Masse, wobei ein jeweiliger Strom, der durch die Vorspannungsstromquelle erzeugt wird, an jeden Lasttransistor geliefert wird zum Aufrechterhalten einer Vorwärts-Basis-Emitter-Spannung ($V_{BE}$) von jedem Lasttransistor; und
einer Lastwiderstandsschaltung einschließlich von zumindest einem Lastwiderstand (R; $R_{21}$, $R_{22}$), verbunden zwischen dem Kollektor eines jeweiligen Lasttransistors (Q; $Q_{21}$, $Q_{22}$) in der Lasttransistorschaltung und einer Leistungsversorgungsspannung ($V_{cc}$), wobei ein Ausgabesignal ($S_{OUT1}$, $S_{OUT2}$) vorgesehen ist an dem Kollektor jedes Lasttransistors;
dadurch **gekennzeichnet,** daß
die Vorspannungsstromquelle einer Stromspiegelschaltung ($CS_2$, $CS_3$) für jeden zu liefernden Strom umfaßt, wobei zumindest eine der Stromspiegelschaltungen verbunden ist mit einer Steuerspannungsquelle ($V_C$) zum Verschieben des Pegels des Ausgabesignals um einen Wert, der durch die Steuerspannungsquelle ($V_C$) definiert ist.

2. Pegelverschiebeschaltung nach Anspruch 1, dadurh gekennzeichnet, daß die Stromantriebsschaltung (ID) erste und zweite Eingabetransistoren ($Q_{11}$ und $Q_{12}$) beinhaltet, die parallel verbunden zum differentiellen Arbeiten ansprechend auf die zwei Eingabesignale ($S_{IN1}$ und $S_{IN2}$), die mit den Basen davon verbunden sind, und eine Stromquelle ($CS_1$), die angeschlossen ist zwischen den Emittern der ersten und zweiten Eingabetransistoren ($Q_{11}$, $Q_{12}$) und Masse, wobei die Lasttransistorschaltung erste und zweite Lasttransistoren ($Q_{21}$ und $Q_{22}$) beinhaltet, die Emitter des ersten Lasttransistors verbunden sind mit dem Kollektor des ersten Eingabetransistors, der Emitter des zweiten Lasttransistors verbunden ist mit dem Kollektor des zweiten Eingabetransistors und die Basen der ersten und zweiten Lasttransistoren gemeinsam verbunden sind und betriebsmäßig auf Masse gelegt sind, wobei die Lastwiderstandsschaltung beinhaltet: zwei Lastwiderstände ($R_{21}$ und $R_{22}$), verbunden mit Kollektoren der ersten und zweiten Lasttransistoren, zum Ausgeben von zwei Ausgabesignalen ($S_{OUT1}$ und $S_{OUT2}$) von Punkten, an denen die Kollektoren und die Lastwiderstände gemeinsam verbunden sind, und wobei die Stromspiegelschaltung erste bis dritte Stromquellentransistoren ($Q_4$, $Q_5$ und $Q_{14}$; $Q_8$, $Q_9$ und $Q_{13}$), die parallel verbunden sind, beinhaltet, wobei Kollektoren der ersten und zweiten Stromquellentransistoren ($Q_4$, $Q_5$; $Q_8$, $Q_9$) jeweils verbunden sind mit den Emittern der ersten und zweiten Lasttransistoren, wobei die Steuerspannnungsquelle ($V_C$) verbunden ist mit einem Kollektor des dritten Stromquellentransistors ($Q_{14}$), wobei der Kollektor des dritten Stromquellentransistors ($Q_{14}$; $Q_{14}$) verbunden ist mit einer Basis davon, die gemeinsam verbunden ist mit der Basis des zweiten Stromquellentransistors ($Q_5$; $Q_9$), und wobei zweite bis vierte Stromquellenwiderstände ($R_4$, $R_5$ und $R_{12}$; $R_4$, $R_5$ und $R_{10}$), jeweils angeschlossen zwischen Emittern der ersten bis dritten Stromquellentransistoren und Masse.

3. Pegelverschiebeschaltung nach Anspruch 1, dadurch gekennzeichnet, daß die Stromantriebsschaltung (ID) erste und zweiten Eingabetransistoren ($Q_{11}$ und $Q_{12}$) enthält, die parallel verbunden sind, zum differentiellen Arbeiten ansprechend auf zwei Eingabesignale ($S_{IN1}$ und $S_{IN2}$), verbunden mit Basen davon, und eine Stromquelle ($CS_1$), verbunden zwischen Emittern der ersten und zweiten Eingabetransistoren und Masse, wobei die Lasttransistorschaltung erste und zweite Lasttransistoren ($Q_{21}$ und $Q_{22}$) enthält, der

Emitter des ersten Lasttransistors verbunden ist mit dem Kollektor des ersten Eingabetransistors, der Emitter des zweiten Lasttransistors verbunden ist mit dem Kollektor des zweiten Eingabetransistors und Basen der ersten und zweiten Lasttransistoren gemeinsam verbunden sind und betriebsmäßig auf Masse gelegt sind; wobei die Lastwiderstandsschaltung beinhaltet: zwei Lastwiderstände ($R_{21}$ und $R_{22}$), verbunden mit Kollektoren der ersten und zweiten Lasttransistoren, zum Ausgeben von zwei Ausgabesignalen ($S_{OUT1}$ und $S_{OUT2}$) von Punkten, in denen die Kollektoren und die Lastwiderstände gemeinsame verbunden sind, und wobei die Stromspiegelschaltung erste bis dritte Stromquellentransistoren ($Q_4$, $Q_5$ und $Q_{14}$) umfaßt, die parallel verbunden sind, wobei Kollektoren der ersten und zweiten Stromquellentransistoren ($Q_4$, $Q_5$) jeweils verbunden sind mit den Emittern der ersten und zweiten Lasttransistoren, die Steuerspannungsquelle ($V_C$) verbunden ist mit einem Kollektor des dritten Stromquellentransistors ($Q_{14}$), der Kollektor des dritten Stromquellentransistors verbunden ist mit einer Basis davon, die gemeinsam verbunden ist mit den Basen der ersten und zweiten Stromquellentransistoren, und wobei zweite bis vierte Stromquellenwiderstände ($R_4$, $R_5$ und $R_{12}$) jeweils angeschlossen zwischen Emittern der ersten bis dritten Stromquellentransistoren und Masse.

4. Pegelverschiebeschaltung nach Anspruch 2, dadurch gekennzeichnet, daß eine Halteschaltung (FF) angeschlossen ist mit seinen Eingängen an die Lastwiderstandsschaltung.

5. Pegelverschiebeschaltung nach Anspruch 1, dadurch gekennzeichnet, daß die Stromantriebsschaltung (ID) erste und zweite Eingabetransistoren ($Q_{11}$ und $Q_{12}$) beinhaltet, die parallel verbunden sind zum differentiellen Arbeiten entsprechend auf zwei Eingabesignale ($S_{IN1}$ und $S_{IN2}$), die mit Basen davon verbunden sind, und eine Stromquelle ($CS_1$), angeschlossen zwischen den Emittern der ersten und zweiten Eingabetransistoren ($Q_{11}$, $Q_{12}$) und Masse, wobei die Lasttransistorschaltung erste und zweite Lasttransistoren ($Q_{21}$ und $Q_{22}$) beinhaltet, der Emitter des ersten Lasttransistors verbunden ist mit dem Kollektor des ersten Eingabetransistors, der Emitter des zweiten Lasttransistors verbunden ist mit dem Kollektor des zweiten Eingabetransistors und Basen der ersten und zweiten Lasttransistoren gemeinsam verbunden sind und betriebsmäßig aus Masse gelegt sind, wobei die Lastwiderstandsschaltung beinhaltet: zwei Lastwiderstände ($R_{21}$ und $R_{22}$), verbunden mit den Kollektoren der ersten und zweiten Lasttransistoren, zum ausgeben zweier Ausgabesignale ($S_{OUT1}$ und $S_{OUT2}$) von Punkten, an denen die Kollektoren und die Lastwiderstände gemeinsam verbunden sind, und

wobei die Vorspannungsstromquelle beinhaltet: die erste und zweite Stromspiegelschaltung ($CS_2$, $CS_3$), jeweils verbunden mit den ersten und zweiten Lasttransistoren.

6. Pegelverschiebeschaltung nach Anspruch 5, dadurch gekennzeichnet, daß die erste Stromspiegelschaltung verbunden ist mit der Steuerspannungsquelle ($V_C$) zum Ändern eines davon gelieferten Stroms.

7. Pegelverschiebeschaltung nach Anspruch 5, dadurch gekennzeichnet, daß die Stromspiegelschaltung verbunden ist mit der Steuerschaltungsquelle ($V_C$) zum Ändern eines davon gelieferten Stroms.

8. Pegelverschiebeschaltung nach Anspruch 1, dadurch gekennzeichnet, daß eine Vielzahl der Stromantriebsschaltungen ($ID_1$ bis $Id_n$) parallel verbunden sind, wobei jede Stromantriebsschaltung ein Eingabesignal ($S_{IN}$) empfängt, das zu synthetisieren ist, wobei die Vorspannungsstromquelle und der Emitter von zumindest einem Lasttransistor ($Q$) in der Lasttransistorschaltung verbunden sind mit dem gemeinsam verbundenen Kollektoren der parallelen Stromantriebsschaltungen.

9. Pegelverschiebeschaltung nach Anspruch 4, dadurch gekennzeichnet, daß die Halteschaltung (FF) eine Haupthalteschaltung (ML), angetrieben durch einen Zeittakt (CLK), und eine Unterhalteschaltung (SL), angetrieben durch einen invertierten Zeittakt (CLK), enthält.

10. Pegelverschiebeschaltung nach Anspruch 9, dadurch gekennzeichnet, daß die Haupthalteschaltung (ML) umfaßt:
ein erstes Paar von Emitterfolger-Transistoren ($Q_{40}$, $Q_{41}$) die parallel verbunden sind, mit ihren Basen verbunden mit der Lastwiderstandsschaltung, ihren Kollektoren verbunden mit ihrer Leistungsversorgungsschaltung ($V_{CC}$) ihre jeweiligen Lastwiderstände ($R_{41}$, $R_{42}$), und ihren Emittern verbunden mit einem Transistor ($Q_{42}$), der den Zeittakt (CLK) an seiner Basis empfängt; und
ein zweites Paar von Emitterfolger-Transistoren ($Q_{41}$, $Q_{42}$), die parallel verbunden sind, mit ihren Basen verbunden mit den jeweiligen Kollektoren des ersten Paares von Emitterfolger-Transistoren ($Q_{40}$, $Q_{41}$) und mit ihren Emittern verbunden mit einem Transistor ($Q_{45}$), der eine Referenzsspannung ($V_S$) an seiner Basis empfängt;

wobei die Emitter der Transistoren ($Q_{42}$, $Q_{45}$) mit einer Konstantstromquelle ($CS_4$) verbunden sind.

## Revendications

1. Circuit de décalage de niveau comprenant :
un circuit de commande de courant (ID) incluant au moins un transistor d'entrée ($Q_{11}$, $Q_{12}$; $Q_{30}$, $Q_{40}$), son émetteur étant mis à la masse en fonctionnement et sa base recevant un signal d'entrée respectif ($S_{IN1}$; $S_{IN2}$) ;
un circuit de transistor de charge incluant au moins un transistor de charge ($Q$ ; $Q_{21}$ ; $Q_{22}$), la base de chaque transistor de charge étant mise à la masse en fonctionnement, l'émetteur de chaque transistor de charge étant connecté au collecteur d'un transistor d'entrée respectif ($Q_{11}$, $Q_{12}$ ; $Q_{30}$, $Q_{40}$) ;
une source de courant de polarisation connectée entre ledit émetteur dudit transistor de charge et une masse, un courant respectif généré par ladite source de courant de polarisation étant appliqué à chaque transistor de charge pour maintenir une tension base-émetteur en sens direct ($V_{BE}$) de chaque transistor de charge ; et
un circuit de résistance de charge incluant au moins une résistance de charge ($R$ ; $R_{21}$, $R_{22}$) connectée entre le collecteur d'un transistor de charge respectif ($Q$ ; $Q_{21}$, $Q_{22}$) dans ledit circuit de transistor de charge et une tension d'alimentation ($V_{CC}$), un signal de sortie ($S_{OUT1}$, $S_{OUT2}$) étant prévu au niveau du collecteur de chaque transistor de charge,
caractérisé en ce que
ladite source de courant de polarisation comprend un circuit miroir de courant ($CS_2$, $CS_3$) pour chaque courant devant être généré, au moins l'un desdits circuits miroirs de courant étant connecté à une source de tension de commande ($V_c$) pour décaler le niveau dudit signal de sortie d'une valeur définie par la source de tension de commande ($V_c$).

2. Circuit de décalage de niveau selon la revendication 1, caractérisé en ce que ledit circuit de commande de courant (ID) inclut des premier et second transistors d'entrée ($Q_{11}$ et $Q_{12}$) connectés en parallèle de manière à fonctionner de façon différentielle en réponse à deux signaux d'entrée ($S_{IN1}$ et $S_{IN2}$) connectés à leurs bases et une source de courant ($CS_1$) connectée entre des émetteurs desdits premier et second transistors ($Q_{11}$, $Q_{12}$) et la masse ;
ledit circuit de transistor de charge inclut des premier et second transistors de charge ($Q_{21}$

et $Q_{22}$), l'émetteur dudit premier transistor de charge étant connecté au collecteur dudit premier transistor d'entrée, l'émetteur dudit second transistor de charge étant connecté au collecteur dudit second transistor d'entrée et les bases desdits premier et second transistors de charge étant connectées en commun et mises à la masse en fonctionnement,

ledit circuit de résistance de charge inclut :

deux résistances de charge ($R_{21}$ et $R_{22}$) respectivement connectées aux collecteurs desdits premier et second transistors de charge, afin de générer en sortie deux signaux de sortie ($S_{OUT1}$ et $S_{OUT2}$) à partir de points au niveau desquels lesdits collecteurs et lesdites résistances de charge sont connectés en commun ; et

ledit circuit miroir de courant inclut des premier à troisième transistors de source de courant ($Q_4$ ; $Q_5$ et $Q_{14}$ ; $Q_8$, $Q_9$ et $Q_{13}$) connectés en parallèle, les collecteurs desdits premier et second transistors de source de courant ($Q_4$, $Q_5$ ; $Q_8$, $Q_9$) étant respectivement connectés auxdits émetteurs desdits premier et second transistors de charge, la source de tension de commande (VC) étant connectée à un collecteur dudit troisième transistor de source de courant ($Q_{14}$), le collecteur dudit troisième transistor de source de courant ($Q_{14}$ ; $Q_{13}$) étant connecté à sa base qui est connectée en commun à la base dudit second transistor de source de courant ($Q_5$ ; $Q_9$) et des seconde à quatrième résistances de source de courant ($R_4$, $R_5$ et $R_{12}$ ; $R_4$, $R_5$ et $R_{10}$) respectivement connectées entre les émetteurs desdits premier à troisième transistors de source de courant et la masse.

3. Circuit de décalage de niveau selon la revendication 1, caractérisé en ce que ledit circuit de commande de courant (ID) inclut des premier et second transistors d'entrée ($Q_{11}$ et $Q_{12}$) connectés en parallèle de manière à fonctionner de façon différentielle en réponse à deux signaux d'entrée ($S_{IN1}$ et $S_{IN2}$) connectés à leurs bases et une source de courant ($CS_1$) connectée entre les émetteurs desdits premier et second transistors d'entrée et la masse,

ledit circuit de transistor de charge inclut des premier et second transistors de charge ($Q_{21}$ et $Q_{22}$), l'émetteur dudit premier transistor de charge étant connecté au collecteur dudit premier transistor d'entrée, l'émetteur dudit second transistor de charge étant connecté au collecteur dudit second transistor d'entrée et les bases desdits premier et second transistors de charge étant connectées en commun et mises à la masse en fonctionnement,

ladite résistance de charge inclut :

deux résistances de charge ($R_{21}$ et $R_{22}$)

respectivement connectées aux collecteurs desdits premier et second transistors de charge, afin de générer en sortie deux signaux de sortie ($S_{OUT1}$ et $S_{OUT2}$) à partir de points au niveau desquels lesdits collecteurs et lesdites résistances de charge sont connectés en commun ; et

ledit circuit miroir de courant inclut des premier à troisième transistors de source de courant ($Q_4$, $Q_5$ et $Q_{14}$) connectés en parallèle, les collecteurs desdits premier et second transistors de source de courant ($Q_4$, $Q_5$) étant respectivement connectés auxdits émetteurs desdits premier et second transistors de charge, la source de tension de commande ($V_C$) étant connectée à un collecteur dudit troisième transistor de source de courant ($Q_{14}$), le collecteur dudit troisième transistor de source de courant étant connecté à sa base qui est connectée en commun aux bases desdits premier et second transistors de source de courant, et desdites seconde à quatrième résistances de source de courant ($R_4$, $R_5$ et $R_{12}$) sont respectivement connectées entre les émetteurs desdits premier à troisième transistors de source de courant et la masse.

4. Circuit de décalage de niveau selon la revendication 2, caractérisé en ce qu'un circuit de bascule (FF) est connecté par ses entrées audit circuit de résistance de charge.

5. Circuit de décalage de niveau selon la revendication 1, caractérisé en ce que :

ledit circuit de commande de courant (ID) inclut des premier et second transistors d'entrée ($Q_{11}$ et $Q_{12}$) connectés en parallèle de manière à fonctionner de façon différentielle en réponse à deux signaux d'entrée ($S_{IN1}$ et $S_{IN2}$) connectés à leurs bases et une source de courant ($CS_1$) connectée entre les émetteurs desdits premier et second transistors d'entrée ($Q_{11}$, $Q_{12}$) et la masse,

ledit circuit de transistor de charge inclut des premier et second transistors de charge ($Q_{21}$ et $Q_{22}$), l'émetteur dudit premier transistor de charge étant connecté au collecteur dudit premier transistor d'entrée, l'émetteur dudit second transistor de charge étant connecté au collecteur dudit second transistor d'entrée et les bases desdits premier et second transistors de charge étant connectées en commun et mises à la masse en fonctionnement,

ledit circuit de résistance de charge inclut :

deux résistances de charge ($R_{21}$ et $R_{22}$) respectivement connectées aux collecteurs desdits premier et second transistors de charge, afin de générer en sortie deux signaux de sortie ($S_{OUT1}$ et $S_{OUT2}$) à partir de points au niveau desquels lesdits collecteurs et lesdites résistances de charge sont connectés en commun, et

ladite source de courant de polarisation inclut :

les premier et second circuits miroirs de courant ($CS_2$, $CS_3$) connectés auxdits premier et second transistors de charge.

6. Circuit de décalage de niveau selon la revendication 5, caractérisé en ce que ledit premier circuit miroir de courant est connecté à la source de tension de commande ($V_C$) pour modifier un courant généré par celle-ci.

7. Circuit de décalage de niveau selon la revendication 5, caractérisé en ce que ledit second circuit miroir de courant est connecté à la source de tension de commande ($V_C$) pour modifier un courant généré par celle-ci.

8. Circuit de décalage de niveau selon la revendication 1, caractérisé en ce qu'une pluralité desdits circuits de commande de courant ($ID_1$ à $ID_n$) sont connectés en parallèle, chaque circuit de commande de courant se voyant appliquer un dit signal d'entrée ($S_{IN}$) devant être synthétisé, ladite source de courant de polarisation et ledit émetteur dudit au moins un transistor de charge ($Q$) dans ledit circuit de transistor de charge sont connectés aux collecteurs connectés en commun desdits circuits de commande de courant parallèles.

9. Circuit de décalage de niveau selon la revendication 4, caractérisé en ce que ledit circuit de bascule (FF) inclut un circuit de bascule maître (ML) commandé par un signal d'horloge (CLK) et un circuit de bascule esclave (SL) commandé par un signal d'horloge inversé (CLK).

10. Circuit de décalage de niveau selon la revendication 9, caractérisé en ce que ledit circuit de bascule maître (ML) comprend :

une première paire de transistors en suiveurs d'émetteur ($Q_{40}$, $Q_{41}$) connectés en parallèle, leurs bases étant connectées audit circuit de résistance de charge, leurs collecteurs étant connectés à une tension d'alimentation ($V_{cc}$) via des résistances de charge respectives ($R_{41}$, $R_{42}$) et leurs émetteurs étant connectés à un transistor ($Q_{42}$) qui se voit appliquer ledit signal d'horloge (CLK) au niveau de sa base ; et

une seconde paire de transistors en suiveurs d'émetteur ($Q_{43}$, $Q_{44}$) connectés en parallèle, leurs bases étant connectées aux collecteurs respectifs de la première paire de transistors en suiveurs d'émetteur ($Q_{40}$, $Q_{41}$) et leurs émetteurs étant connectés à un transistor ($Q_{45}$) qui reçoit une tension de référence ($V_S$) au niveau de sa base ;

dans lequel les émetteurs desdits transistors ($Q_{42}$, $Q_{45}$) sont connectés à une source de courant constant ($CS_4$).

EP 0 329 793 B1

*Fig. 1a* PRIOR ART

$S_{IN}$ Q
$\ell$
$S_{OUT}$
R
C
CH1 CH2

*Fig. 1b* PRIOR ART

$S_{IN}$ Q
$\ell$
$S_{OUT}$
CS
C
CH1 CH2

*Fig. 1c* PRIOR ART

$\ell$ $R_2$
$S_{OUT}$
$S_{IN}$ Q
$R_2$
C
CH1 CH2

*Fig. 1d* PRIOR ART

$R_{11}$ $R_{12}$
$\ell_1$ $\ell_2$
$Q_1$ $Q_2$ $S_{OUT1}$ $S_{OUT2}$
$S_{IN1}$
$S_{IN2}$
CS $C_1$ $C_2$
CH1 CH2

*Fig. 2a* PRIOR ART

LEVEL (dB)
CV1a
CV1b
1  10  GHz
FREQUENCY

*Fig. 2b* PRIOR ART

LEVEL (dB)
CV2a
CV2b
CV2c
1  10  GHz
FREQUENCY

19

# Fig.3

# Fig.5a

# Fig.4

# Fig.5b

Fig. 6a

Fig. 6b

Fig. 7a

Fig. 7b

21

# Fig. 8a

# Fig. 8b

# Fig. 9a

# Fig. 9b

Fig. 10a

Fig. 10b

Fig. 10c

Fig. 10d

Fig. 11 PRIOR ART

Fig. 12 PRIOR ART

Fig. 13 PRIOR ART

*Fig.14*

*Fig.15*

*Fig. 16*

*Fig. 17*

EP 0 329 793 B1

*Fig. 18*

*Fig. 19*

EP 0 329 793 B1

## Fig. 20
PRIOR ART

$R_{VR}$

E Q L
A M P

S10A
S10B

}TO 12

10

## Fig. 21

UL
ADJUST RANGE
LL

L

## Fig. 22a

L

## Fig. 22b

L

## Fig. 23a

L
SLL

## Fig. 23b

SLu
L

28

## Fig. 24

## Fig. 25

# Fig. 26

# Fig. 27

Fig. 28 PRIOR ART

Fig. 29 PRIOR ART

Fig. 30

Fig. 31

# Fig.32

# Fig.33

Fig. 34

Fig. 35

Fig. 36

Fig. 37

## *Fig. 38* PRIOR ART

## *Fig. 39* PRIOR ART

## Fig. 40

## Fig. 41

# Fig. 42

# Fig. 43

EXPLANATION OF REFERENCES

ID .... drive current soruce

$CS_0$ ... bias current source

Q ..... load transistor

R ..... load resistor